# EUROPEAN PATENT APPLICATION

(11) **EP 4 557 912 A1**
(43) Date of publication of application: **21.05.2025**
(21) Application number: 24208688.2
(22) Date of filing: 24.10.2024
(51) Int. Cl.: H10D 86/40

(54) **DISPLAY DEVICE**

(30) Priority: 30.10.2023 KR 20230147099
(71) Applicant: Samsung Display Co., Ltd., Gyeonggi-do 17113 (KR)
(72) Inventor: JU, Jin Ho, 17113 Yongin-si (KR); CHOI, Jong Hyun, 17113 Yongin-si (KR)
(74) Representative: Walaski, Jan Filip

(57) **Abstract**

A display device includes a plurality of unit pixel areas arranged in a first and second direction and in which first and second thin film transistors are located; a valley portion at boundaries of the unit pixel areas, extending in the first direction, at least partially extending in the second direction, and penetrating through at least some of a plurality of insulating layers; and a capping layer positioned to overlap with the valley portion and positioned to cover inner sidewalls of the valley portion, the capping layer being on a portion of the valley portion that is adjacent to a semiconductor area of one of the unit pixel areas, where the second active layer is located, and is between the second active layer and an organic insulating material in the valley portion.

## Description

### CROSS-REFERENCE TO RELATED APPLICATION

The present application claims priority to Korean Patent Application No. 10-2023-0147099, filed on 30 October 2023 in the Korean Intellectual Property Office.

### BACKGROUND

### 1. Field

The disclosure relates to a display device.

### 2. Description of the Related Art

As the information society has developed, the demand for display devices for displaying images has increased and diversified. For example, display devices have been applied to various electronic devices, such as smartphones, digital cameras, laptop computers, navigation devices, and smart televisions. The display devices may be flat panel display devices, such as liquid crystal display devices, field emission display devices, or organic light emitting display devices. Among such flat panel display devices, a light emitting display device may display an image without a backlight unit providing light to a display panel because each of pixels of the display panel includes light emitting elements that may themselves emit light.

The display device may further include pixels emitting predetermined light, scan lines, data lines, and power lines for driving the pixels, a scan driver outputting scan signals to the scan lines, and a display driver outputting data voltages to the data lines. The above information disclosed in this Background section is only for enhancement of understanding of the background of the invention and therefore it may contain information that does not form the prior art.

### SUMMARY

According to some embodiments of the present disclosure, there is provided a display device capable of preventing damage to circuit elements from an external shock and preventing deterioration of the circuit elements.

However, aspects of the disclosure are not restricted to those set forth herein. The above and other aspects of the disclosure will become more apparent to one of ordinary skill in the art to which the disclosure pertains by referencing the detailed description of the disclosure given below.

According to some embodiments of the disclosure, there is provided a display device including: a plurality of unit pixel areas arranged in a first direction and a second direction crossing the first direction and in which first thin film transistors and second thin film transistors are located, each one of first thin film transistors including a first active layer, and each one of the second thin film transistors including a second active layer at a different layer from the first active layer and including an oxide semiconductor; a valley portion at boundaries of the unit pixel areas, extending in the first direction, at least partially extending in the second direction, and penetrating through at least some of a plurality of insulating layers overlapping with the first thin film transistor and the second thin film transistor, at least a portion of the valley portion overlapping with the second active layer in a horizontal direction; and a capping layer positioned to overlap with the valley portion and positioned to cover inner sidewalls of the valley portion, the capping layer being on a portion of the valley portion that is adjacent to a semiconductor area of one of the unit pixel areas where the second active layer is located, and is between the second active layer and an organic insulating material in the valley portion.

In one or more embodiments, a shortest distance between the capping layer and the second active layer may be about 10 µm or less.

In one or more embodiments, the capping layer may include at least one of SiNx, SiOx, or SiOxNy.

In one or more embodiments, the display device may further include a plurality of lines electrically connected to at least one of the first thin film transistors or the second thin film transistors and extending in the first direction or the second direction, wherein at least a portion of the valley portion overlaps with any one of the lines.

In one or more embodiments, a depth of a portion of the valley portion that does not overlap with the lines may be greater than a depth of the portion of the valley portion that overlaps with any one of the lines.

In one or more embodiments, the capping layer may include first capping patterns on the inner sidewalls of the valley portion and second capping patterns that are not connected to the first capping patterns and located on the lines that overlap with the valley portion.

In one or more embodiments, the valley portion may be configured to extend in the first direction and the second direction to surround the unit pixel area, and the capping layer may include portions overlapping with the valley portion and extending in the first direction and the second direction.

In one or more embodiments, the second active layer may be adjacent to a portion of the valley portion extending in the second direction, and the capping layer may be on the portion of the valley portion extending in the second direction.

In one or more embodiments, a width of the capping layer measured in the second direction may be about the same as a width measured in the second direction of the semiconductor area.

In one or more embodiments, the portion of the capping layer extending in the first direction may be located on a portion of the valley portion extending in the first direction, and the capping layer may not be located on at least a portion of the portion of the valley portion extending in the first direction.

In one or more embodiments, the capping layer may be configured to extend in the first direction and the second direction to surround the unit pixel area.

In one or more embodiments, the valley portion may include a portion extending in the first direction and a portion protruding in the second direction from the portion extending in the first direction and located at the boundary of the unit pixel area, and the valley portion and the capping layer may not be located between semiconductor areas of the unit pixel areas arranged in the second direction.

In one or more embodiments, the display device may further include: a gate electrode on the second active layer and a step pattern located at the same layer as the gate electrode and overlapping with a portion of the valley portion extending in the second direction. The capping layer may be on and in direct contact with the step pattern.

In one or more embodiments, a portion of the valley portion on the step pattern has a smaller depth than other portions, and the capping layer on the step pattern may not overlap with the second active layer in the horizontal direction.

According to some embodiments of the present disclosure, there is provided a display device including: a plurality of unit pixel areas arranged in a first direction and a second direction crossing the first direction and in which first thin film transistors and second thin film transistors are located, each of the first thin film transistors including a first active layer, and each of the second thin film transistors including a second active layer at a different layer from the first active layer and including an oxide semiconductor; and a valley portion at boundaries of the unit pixel areas, extending in the first direction, at least partially extending in the second direction, and penetrating through at least some of a plurality of insulating layers overlapping with the first thin film transistor and the second thin film transistor. The second active layer is adjacent to one side of the unit pixel area, and the valley portion is formed so as not to penetrate a gate insulating layer covering the second active layer on the one side of the unit pixel area adjacent to a semiconductor area where the second active layer is located.

In one or more embodiments, the valley portion may include a portion extending in the first direction and a portion protruding in the second direction from the portion extending in the first direction and located at the boundary of the unit pixel area.

In one or more embodiments, the valley portion may not be formed between semiconductor areas of the unit pixel areas arranged in the second direction.

In one or more embodiments, the display device may further include a gate electrode overlapping with the second active layer and a step pattern located at the same layer as the gate electrode and overlapping with a portion of the valley portion extending in the second direction. The valley portion may be configured to extend in the first direction and the second direction to surround the unit pixel area.

In one or more embodiments, a portion of the valley portion located on the step pattern may have a smaller depth than other portions.

In one or more embodiments, the step pattern may be located on the gate insulating layer covering the second active layer. The valley portion may not penetrate through the gate insulating layer overlapping with the step pattern.

A display device according to some embodiments may include a valley portion surrounding an area where pixel circuits are disposed and a capping layer covering inner sidewalls of the valley portion. The valley portion may absorb an external shock, and the capping layer may prevent gas generated from an organic insulating material from moving to adjacent circuit elements. Accordingly, the display device may prevent or substantially reduce damage to the circuit elements due to an external shock and deterioration of the circuit elements due to the gas.

In addition, when the display device has flexible characteristics, cracks that may be formed in a plurality of insulating layers disposed on a substrate when the substrate is folded may be prevented by the valley portion.

The effects of the disclosure are not limited to the aforementioned effects, and various other effects are included in the specification.

### BRIEF DESCRIPTION OF THE DRAWINGS

The above and other aspects and features of the disclosure will become more apparent by describing in detail embodiments thereof with reference to the attached drawings, in which:
FIG. 1 illustrates a perspective view of a display device;
FIG. 2 illustrates a plan view illustrating the display device of FIG. 1;
FIG. 3 illustrates a cross-sectional view taken along the line A-A' of FIG. 2;
FIG. 4 illustrates a plan view illustrating a display panel;
FIG. 5 illustrates a pixel circuit diagram of a sub-pixel;
FIG. 6 illustrates a pixel circuit diagram of a sub-pixel;
FIG. 7 illustrates a plan view illustrating an arrangement of a plurality of pixel circuits disposed in a display area of the display device;
FIG. 8 illustrates a plan view illustrating pixel circuits disposed in a unit pixel area of FIG. 7;
FIG. 9 illustrates a cross-sectional view taken along the line IX-IX' of FIG. 8;
FIG. 10 illustrates a plan view illustrating an arrangement of the unit pixel area and a semiconductor layer area of the display device;
FIG. 11 illustrates a cross-sectional view taken along the line XI-XI' of FIG. 10;
FIG. 12 illustrates a cross-sectional view taken along the line XII-XII' of FIG. 10;
FIG. 13 illustrates a plan view illustrating a unit pixel area and a valley portion of a display device;
FIG. 14 illustrates a cross-sectional view taken along the line A1-A1' of FIG. 13;
FIG. 15 illustrates a plan view illustrating a unit pixel area and a valley portion of a display device;
FIG. 16 illustrates a plan view illustrating a unit pixel area and a valley portion of a display device;
FIG. 17 illustrates a cross-sectional view taken along the line A2-A2' of FIG. 16;
FIG. 18 illustrates a plan view illustrating a unit pixel area and a valley portion of a display device;
FIG. 19 illustrates a cross-sectional view taken along the line A3-A3' of FIG. 18;
FIG. 20 illustrates a plan view illustrating a unit pixel area and a valley portion of a display device;
FIG. 21 illustrates a cross-sectional view taken along the line A4-A4' of FIG. 20;
FIG. 22 illustrates a plan view illustrating a unit pixel area and a valley portion of a display device; and
FIG. 23 illustrates a cross-sectional view taken along the line A5-A5' of FIG. 22.

### DETAILED DESCRIPTION

The present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element. Hereinafter, embodiments will be described with reference to the accompanying drawings.

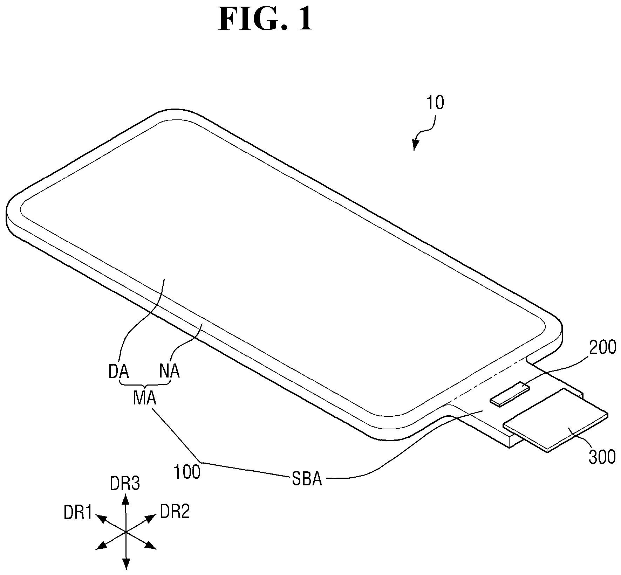

FIG. 1 is a perspective view of a display device.

Referring to FIG. 1, a display device 10 is a device that displays a moving image or a still image, and may be used as a display screen of various suitable products, such as televisions, laptop computers, monitors, billboards, and the Internet of Things (IOT), as well as portable electronic devices, such as mobile phones, smartphones, tablet personal computers (PCs), smart watches, watch phones, mobile communication terminals, electronic notebooks, electronic books, portable multimedia players (PMPs), navigation devices, and ultra mobile PCs (UMPCs).

The display device 10 may be a light emitting display device, such as an organic light emitting display device, including organic light emitting diodes, a quantum dot light emitting display device including quantum dot light emitting layers, an inorganic light emitting display device including inorganic semiconductors, or a micro light emitting display device using micro or nano light emitting diodes (micro LEDs or nano LEDs). Hereinafter, implementations in which the display device 10 is an organic light emitting display device has been described, but a type of the display device 10 is not limited thereto.

The display device 10 may be formed to be flat. For example, the display device 10 may be formed to be substantially flat on a plane defined by a first direction DR1 and a second direction DR2, and may have a preset thickness (or height) in a third direction DR3. In another implementation, the display device 10 may include curved portions in at least a portion thereof, including an edge area or the like. In addition, the display device 10 may be flexibly formed to be curved, bent, folded, or rolled.

Based on an image display surface of the display device 10, the first direction DR1 may be a longitudinal direction, a column direction, or a vertical direction, and the second direction DR2 is a direction crossing the first direction DR1 and may be, for example, a transverse direction, a row direction, or a horizontal direction. The third direction DR3 may be a thickness direction or a height direction of the display device 10.

The display device 10 may include a display panel 100, a driver 200, and a circuit board 300.

The display panel 100 may include a main area MA, including a display area DA, where an image is displayed, and a sub-area SBA positioned on one side of the main area MA.

The main area MA may include the display area DA and a non-display area NA positioned around the display area DA. The display area DA may be positioned at the center of the main area MA, and may occupy most of the main area MA. The non-display area NA may be positioned at an edge of the main area MA, and may be in contact with the sub-area SBA.

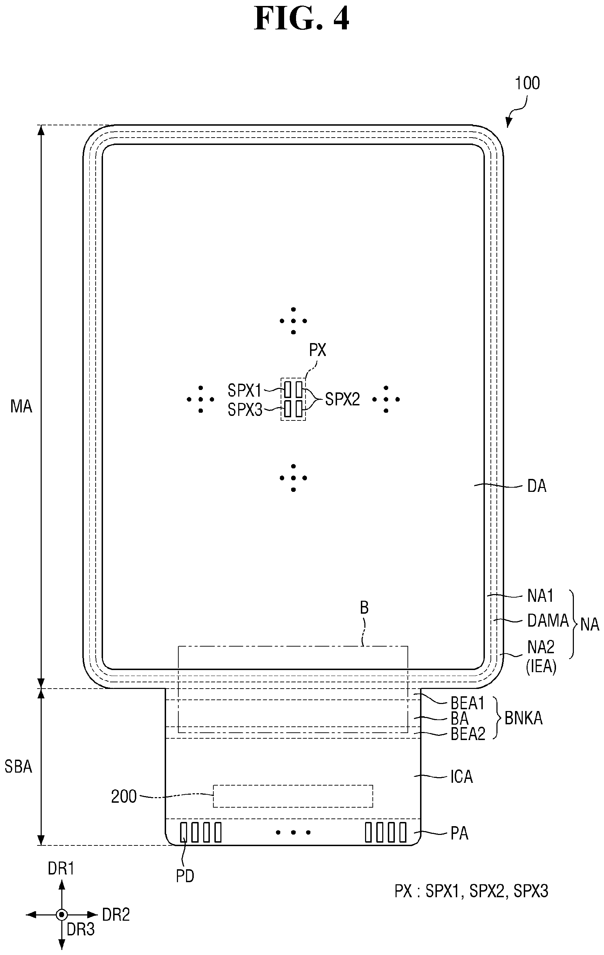

The display area DA is an area where pixels (e.g., pixels PX of FIG. 4) are arranged, and may be an area where an image is displayed by the pixels PX. The display area DA may be further provided with sensing patterns (e.g., touch electrodes) for sensing a touch input or the like, and may include a sensing area sensing the touch input by the sensing patterns.

The display area DA may be formed in a substantially rectangular shape, in a plan view, including long sides in the first direction DR1 and short sides in the second direction DR2. A corner portion where the long side and the short side of the display area DA meet may be rounded or right-angled. A shape of the display area DA may be variously changed. For example, the display area DA may also be formed in other polygonal shapes other than the rectangular shape, a circular shape, an elliptical shape, or the like.

The non-display area NA may be positioned immediately around the display area DA. The non-display area NA may surround the display area DA. An embedded circuit may be disposed in (i.e., positioned in or located in) the non-display area NA. For example, an embedded circuit including a scan driving circuit or the like may be disposed in the non-display area NA positioned on one side (e.g., the left side or the right side) or both sides of the display area DA.

The sub-area SBA may be positioned on one side of the main area MA. For example, the sub-area SBA may be an area protruding from one side of the main area MA in the first direction DR1. As an example, the sub-area SBA may protrude from a lower end of the main area MA in the first direction DR1. The sub-area SBA may have a smaller width than the main area MA. For example, based on the second direction DR2, the sub-area SBA may have a smaller width than the main area MA.

Lines and pads may be disposed in the sub-area SBA. For example, lines and pads connected to the pixels and/or the embedded circuit positioned in the main area MA and the driver 200 and/or the circuit board 300 positioned in the sub-area SBA may be disposed in the sub-area SBA. The term "connection" may include the meaning of an electrical connection and/or a physical connection.

The driver 200 (e.g., a display driving circuit) may be mounted in the sub-area SBA. The circuit board 300 may be disposed on a portion of the sub-area SBA.

The driver 200 may include a data driving circuit for driving the pixels. The driver 200 may be formed as an integrated circuit (IC) and disposed in the sub-area SBA. In another implementation, the driver 200 may be disposed on the circuit board 300 on the sub-area SBA or be disposed on another circuit board connected to the display panel 100 through the circuit board 300.

The circuit board 300 may be disposed on a portion of the sub-area SBA. For example, the circuit board 300 may be bonded onto pads positioned at a portion (e.g., a lower edge) of the sub-area SBA, and may supply or transfer source voltages and driving signals for driving the display panel 100 to the display panel 100. For example, the circuit board 300 may supply input image data (e.g., digital image data), driving signals including timing signals, and driving voltages to the display panel 100. The circuit board 300 may be a flexible printed circuit board (FPCB), a printed circuit board (PCB), or a flexible film such as a chip on film (COF), but is not limited thereto.

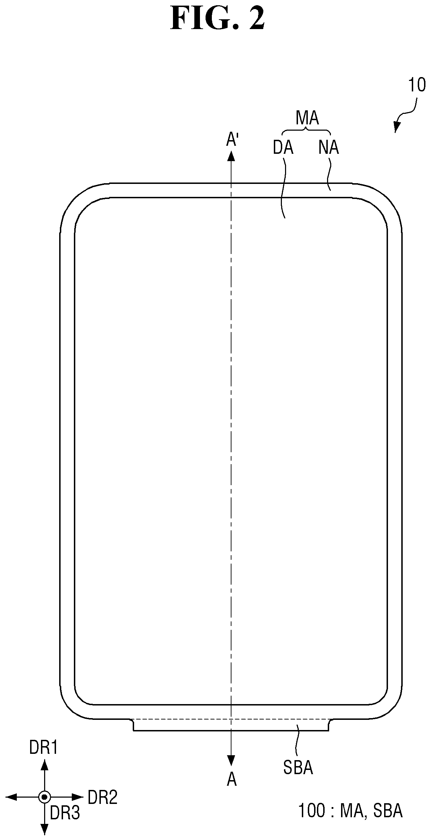

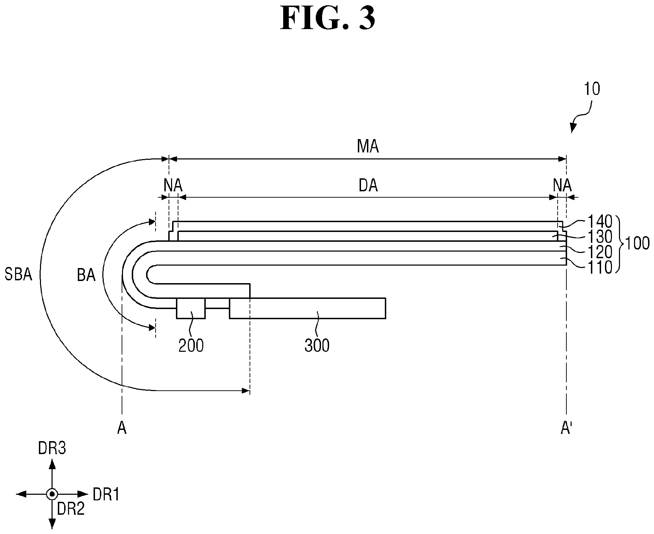

FIG. 2 is a plan view illustrating the display device of FIG. 1. FIG. 3 is a cross-sectional view taken along the line A-A' of FIG. 2.

FIG. 1 illustrates a state in which the display device 10 is not bent but is unbent, and FIGS. 2 and 3 illustrate a state in which the display device 10 is bent in the sub-area SBA. FIG. 1 illustrates a state in which the sub-area SBA is unbent in parallel with the main area MA, and FIGS. 2 and 3 illustrate a state in which a portion of the sub-area SBA is bent.

Referring to FIGS. 2 and 3, the display panel 100 may include a substrate 110 including a main area MA and a sub-area SBA, a circuit layer 120, a light emitting element layer 130, and an encapsulation layer 140 that are sequentially disposed on the substrate 110. The circuit layer 120 may be positioned in the main area MA and the sub-area SBA on the substrate 110. The light emitting element layer 130 and the encapsulation layer 140 may be positioned on portions of the substrate 110 and the circuit layer 120. For example, the light emitting element layer 130 and the encapsulation layer 140 may be positioned in the main area MA.

The display device 10 may further include additional components disposed on the display panel 100. For example, the display device 10 may further include at least one of a sensor layer (e.g., a touch sensor layer), a polarization layer, a color filter layer, and/or a protective layer (e.g., a window) disposed on the encapsulation layer 140. Each of the sensor layer, the polarization layer, the color filter layer, and/or the protective layer may be manufactured integrally with the display panel 100 or may be manufactured separately from the display panel 100 and attached to the display panel 100 via an adhesive layer or the like.

The substrate 110 may include an insulating material, such as a polymer resin. For example, the substrate 110 may be made of polyimide or other insulating materials. The substrate 110 may be a flexible substrate that may be deformed, for example, bent, folded, and rolled. The substrate 110 may include an insulating material such as glass.

The circuit layer 120 may include pixel circuits and lines. For example, the circuit layer 120 may include circuit elements (e.g., pixel transistors and a capacitor) constituting a pixel circuit of each of the pixels and lines connected to the pixels. The circuit layer 120 may further include circuit elements constituting the embedded circuit such as the scan driving circuit and lines connected to the embedded circuit.

The light emitting element layer 130 may include light emitting elements disposed in emission areas of the pixels. For example, each of the pixels may include at least one light emitting element and a pixel circuit connected to the light emitting element. Each of the pixels may be positioned in a respective pixel area including the emission area where the light emitting element is disposed and a pixel circuit area where the pixel circuit is disposed. The emission area and the pixel circuit area of each pixel may overlap each other, but are not limited thereto.

In describing some embodiments, the circuit layer 120 and the light emitting element layer 130 have been separately described, but embodiments are not limited thereto. For example, the circuit layer 120 and the light emitting element layer 130 may be integrated with each other.

The encapsulation layer 140 may cover the light emitting element layer 130 and extend to the non-display area NA to be in contact with the circuit layer 120. The encapsulation layer 140 may have a multilayer structure including at least two inorganic encapsulation films overlapping each other and at least one organic encapsulation film interposed between the inorganic encapsulation films.

The display panel 100 may be bent in a bending area BA. The bending area BA may be a portion of the sub-area SBA and may be spaced apart from the main area MA.

The substrate 110 and the circuit layer 120 may be bent in the bending area BA corresponding to a partial section of the sub-area SBA. Accordingly, a bezel area recognized as the non-display area NA by a user may be reduced or minimized.

FIG. 4 is a plan view illustrating a display panel. FIG. 4 illustrates a state in which the display panel 100 is not bent.

Referring to FIG. 4, the display panel 100 may include a main area MA and a sub-area SBA. The main area MA may include a display area DA and a non-display area NA, and the sub-area SBA may include a bank area BNKA, a driving circuit mounting area ICA, a pad area PA, and the like.

The display area DA may be an area where a plurality of pixels PX are disposed. The pixels PX and lines (or portions of the lines) connected to the pixels PX may be disposed in the display area DA.

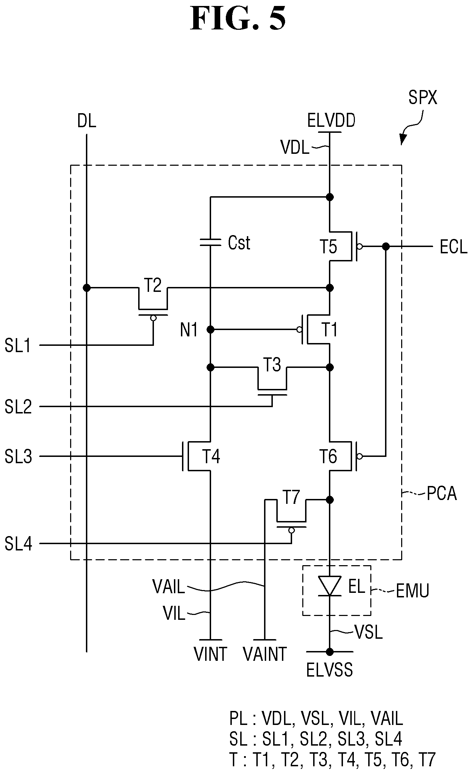

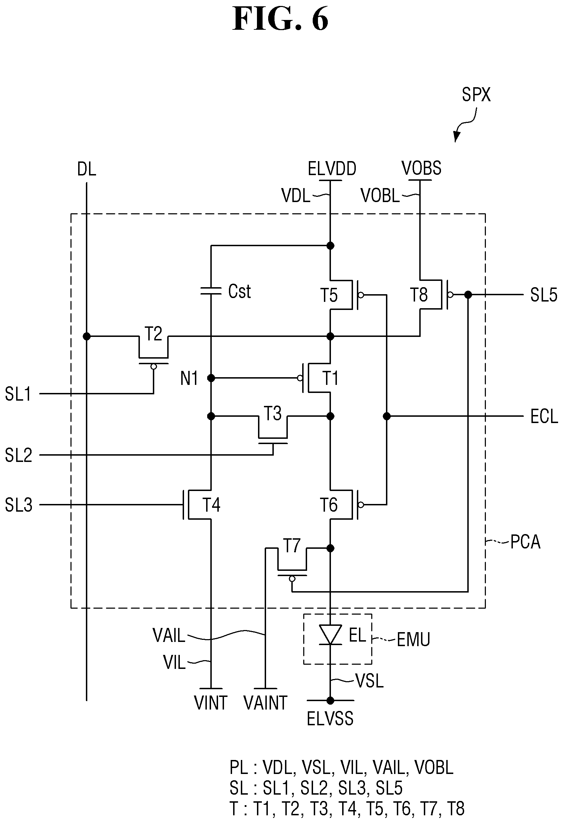

The pixels PX may be provided in the circuit layer 120 and the light emitting element layer 130 of the display panel 100. As an example, each pixel PX may include a pixel circuit (e.g., a pixel circuit PCA of FIG. 5 or 6) including circuit elements disposed in the circuit layer 120 and a light emitting element (e.g., a light emitting element EL of FIG. 5 or 6) disposed in the light emitting element layer 130.

The pixels PX may include at least two color sub-pixels SPX emitting light of different colors. For example, the pixels PX may include first color sub-pixels SPX1 emitting light of a first color (e.g., red light), second color sub-pixels SPX2 emitting light of a second color (e.g., green light), and third color sub-pixels SPX3 emitting light of a third color (e.g., blue light).

At least one first color sub-pixel SPX1, at least one second color sub-pixel SPX2, and at least one third color sub-pixel SPX3 adjacent to each other may constitute one unit pixel PX. For example, one first color sub-pixel SPX1, two second color sub-pixels SPX2, and one third color sub-pixel SPX3 adjacent to each other may constitute one unit pixel PX. Each unit pixel PX may emit light of various suitable colors including white light by mixing colors of light emitted from the sub-pixels SPX1, SPX2, and SPX3 constituting each unit pixel PX with each other. The first color sub-pixels SPX1 and the third color sub-pixels SPX3 may be alternately arranged in the first direction DR1 and/or the second direction DR2, and the second color sub-pixels SPX2 may be continuously and/or sequentially arranged in the first direction DR1. Types, shapes, an arrangement structure, and the like, of the sub-pixels SPX1, SPX2, and SPX3 may be variously changed in a suitable manner. In addition, types, the number, a ratio, an arrangement structure, and the like, of the sub-pixels SPX1, SPX2, and SPX3 constituting each unit pixel PX may also be variously changed in a suitable manner.

The encapsulation layer 140 may be disposed on the pixels PX. For example, the encapsulation layer 140 may be provided in at least the display area DA so as to cover the pixels PX, and a portion of the encapsulation layer 140 may extend to the non-display area NA.

The lines may be provided in the circuit layer 120 and may be positioned in the display area DA and the non-display area NA. In addition, the lines may also be positioned in the sub-area SBA. For example, the lines may extend from the sub-area SBA to the display area DA through the non-display area NA.

The non-display area NA may be positioned around the display area DA. For example, the non-display area NA may be an edge area of the main area MA positioned outside the display area DA.

The non-display area NA may include a dam area DAMA spaced apart from the display area DA, a first non-display area NA1 positioned between the display area DA and the dam area DAMA, and a second non-display area NA2 positioned outside the dam area

DAMA. The dam area DAMA may be an area where a dam surrounding the display area DA is disposed. The second non-display area NA2 may include an inorganic encapsulation area IEA (also referred to as a "bonding area") in which the inorganic encapsulation films of the encapsulation layer 140 are bonded to each other.

The sub-area SBA may include the bank area BNKA, the driving circuit mounting area ICA, and the pad area PA that are sequentially disposed on one side of the main area MA. Lines (or portions of lines), a bank, and pads PD may be disposed in the sub-area SBA. At least some of the lines may extend to the main area MA to be connected to the pixels PX.

The bank area BNKA may be an area where a bank including at least one organic film is disposed. The bank area BNKA may include a bending area BA. For example, the bank area BNKA may include the bending area BA spaced apart from the main area MA, and a first edge area BEA1 and a second edge area BEA2 respectively positioned on both sides of the bending area BA in the first direction DR1. The bank may be provided in the bending area BA and its surrounding areas (e.g., the first edge area BEA1 and the second edge area BEA2 of the bank area BNKA) to cover lines passing through the bending area BA. The display panel 100 may be bent in the bending area BA, such that a portion of the sub-area SBA may be positioned behind the main area MA.

The driving circuit mounting area ICA may be an area where the driver 200 is disposed. Pads for connecting at least some lines to the driver 200 may be disposed in the driving circuit mounting area ICA. For example, input pads for connecting the driver 200 to specific pads (e.g., data input pads) of the pad area PA and output pads for connecting the driver 200 to the pixels PX may be disposed in the driving circuit mounting area ICA.

The driver 200 may not be disposed on the display panel 100. In this case, the display panel 100 may not include the driving circuit mounting area ICA, and only the lines may be disposed in an area between the bank area BNKA and the pad area PA.

The pad area PA may be an area where pads PD for connecting the display panel 100 and/or the driver 200 to the circuit board 300 or the like are disposed. The circuit board 300 may be disposed on or bonded onto the pad area PA.

A plurality of pads PD including power pads and signal pads connected to the pixels PX, the driver 200, the embedded circuit, and the like, may be disposed in the pad area PA. Source voltages for driving the pixels PX, the driver 200, the embedded circuit, and the like, may be supplied to the power pads. Driving signals and/or image data for driving the pixels PX, the driver 200, the embedded circuit, and the like, may be supplied to the signal pads. Types, positions, an arrangement order, the number, and the like, of the pads PD may be variously changed in a suitable manner.

FIG. 5 is a pixel circuit diagram of a sub-pixel. FIG. 6 is a pixel circuit diagram of a sub-pixel.

FIGS. 5 and 6 illustrate different implementations in relation to a pixel circuit PCA and lines connected to the pixel circuit PCA. A configuration of the pixel circuit PCA and types and the number of lines connected to the pixel circuit PCA may be variously changed in a suitable manner.

In FIG. 5, each pixel circuit PCA includes first to seventh transistors T1 to T7. Scan lines SL connected to the sub-pixel SPX of FIG. 5 may include a first scan line SL1, a second scan line SL2, a third scan line SL3, and a fourth scan line SL4. Power lines PL connected to the sub-pixel SPX of FIG. 5 may include a first pixel power line VDL, a second pixel power line VSL, a first initialization power line VIL, and a second initialization power line VAIL. The sub-pixel SPX of FIG. 5 may be connected to an emission control line ECL.

In FIG. 6, each pixel circuit PCA includes first to eighth transistors T1 to T8. Scan lines SL connected to the sub-pixel SPX of FIG. 6 may include a first scan line SL1, a second scan line SL2, a third scan line SL3, and a fifth scan line SL5. Power lines PL connected to the sub-pixel SPX of FIG. 6 may include a first pixel power line VDL, a second pixel power line VSL, a first initialization power line VIL, a second initialization power line VAIL, and a bias power line VOBL. The sub-pixel SPX of FIG. 6 may be connected to an emission control line ECL.

Referring to FIG. 5, the sub-pixel SPX may include a light emitting unit EMU including at least one light emitting element EL and a pixel circuit PCA (also referred to as a "pixel driving unit") connected to the light emitting unit EMU.

The light emitting element EL may be connected between the second pixel power line VSL to which a second pixel source voltage ELVSS is applied and the pixel circuit PCA. The second pixel source voltage ELVSS may be a low-potential pixel driving voltage. The light emitting element EL may be a light source of the sub-pixel SPX, and may emit light by receiving a driving current supplied from the pixel circuit PCA.

The light emitting element EL may be an organic light emitting diode, but is not limited thereto. For example, the light emitting element EL may be an inorganic light emitting element, a quantum dot light emitting element, or other types of light emitting elements.

The pixel circuit PCA may control a light emitting timing and luminance of the light emitting element EL by controlling the driving current supplied to the light emitting element EL. The pixel circuit PCA may include at least one pixel transistor T and a capacitor Cst. The pixel circuit PCA may include pixel transistors T including first to seventh transistors T1 to T7.

The first transistor T1 may include a gate electrode connected to a first node N1, a first electrode electrically connected to the first pixel power line VDL through the fifth transistor T5, and a second electrode electrically connected to the light emitting unit EMU through the sixth transistor T6. One of the first electrode or the second electrode may be a source electrode, and the other of the first electrode or the second electrode may be a drain electrode. The first transistor T1 may control a source-drain current (hereinafter referred to as a "driving current") flowing between the first electrode and the second electrode according to a voltage applied to the gate electrode (e.g., a voltage of the first node N1 corresponding to a voltage of a data signal). For example, the first transistor T1 may be a driving transistor of the sub-pixel SPX.

The second transistor T2 may include a gate electrode connected to the first scan line SL1, a first electrode connected to a data line DL, and a second electrode connected to the first electrode of the first transistor T1. The second transistor T2 may be turned on by a first scan signal supplied to the first scan line SL1 to electrically connect the first electrode of the first transistor T1 and the data line DL to each other. When the second transistor T2 is turned on, a voltage of a data signal supplied to the data line DL may be applied to the first electrode of the first transistor T1.

The third transistor T3 may include a gate electrode connected to the second scan line SL2, a first electrode connected to the second electrode of the first transistor T1, and a second electrode connected to the gate electrode of the first transistor T1 (or the first node N1). The third transistor T3 may be turned on by a second scan signal supplied to the second scan line SL2 to electrically connect the gate electrode and the second electrode of the first transistor T1 to each other. When the third transistor T3 is turned on, the first transistor T1 may be driven as a diode.

The fourth transistor T4 may include a gate electrode connected to the third scan line SL3, a first electrode connected to the gate electrode of the first transistor T1, and a second electrode connected to the first initialization power line VIL. The fourth transistor T4 may be turned on by a third scan signal supplied to the third scan line SL3 to electrically connect the gate electrode of the first transistor T1 and the first initialization power line VIL to each other. When the fourth transistor T4 is turned on, a first initialization voltage VINT (e.g., a gate initialization voltage) of the first initialization power line VIL may be applied to the gate electrode of the first transistor T1.

The fifth transistor T5 may include a gate electrode connected to the emission control line ECL, a first electrode connected to the first pixel power line VDL, and a second electrode connected to the first electrode of the first transistor T1. The fifth transistor T5 may be turned on by an emission control signal supplied to the emission control line ECL to electrically connect the first electrode of the first transistor T1 and the first pixel power line VDL to which a first pixel source voltage ELVDD is applied to each other. When the fifth transistor T5 is turned on, the first pixel source voltage ELVDD may be applied to the first electrode of the first transistor T1. The first pixel source voltage ELVDD may be a high potential pixel driving voltage.

The sixth transistor T6 may include a gate electrode connected to the emission control line ECL, a first electrode connected to the second electrode of the first transistor T1, and a second electrode connected to the light emitting element EL. The sixth transistor T6 may be turned on by an emission control signal supplied to the emission control line ECL to electrically connect the first transistor T1 and the light emitting element EL to each other. When both the fifth transistor T5 and the sixth transistor T6 are turned on, the driving current having a magnitude corresponding to the voltage of the gate electrode of the first transistor T1 may flow to the light emitting element EL.

The seventh transistor T7 may include a gate electrode connected to the fourth scan line SL4, a first electrode connected to an anode electrode of the light emitting element EL, and a second electrode connected to the second initialization power line VAIL. The seventh transistor T7 may be turned on by a fourth scan signal supplied to the fourth scan line SL4 to electrically connect the anode electrode of the light emitting element EL and the second initialization power line VAIL to each other. The fourth scan signal may be a signal that is the same as or different from the first scan signal. When the seventh transistor T7 is turned on, a second initialization voltage VAINT (e.g., an anode initialization voltage) of the second initialization power line VAIL may be applied to the anode electrode of the light emitting element EL.

The capacitor Cst may be connected between the gate electrode of the first transistor T1 and the first pixel power line VDL. The capacitor Cst may be charged with a voltage corresponding to the voltage of the data signal applied to the gate electrode of the first transistor T1.

An active layer (e.g., a semiconductor pattern including a channel region) of each of the pixel transistors T (e.g., the first to seventh transistors T1 to T7) may include one semiconductor material of polysilicon, amorphous silicon, and/or an oxide semiconductor. Some of the pixel transistors T may be formed as different conductivity-type transistors than the other pixel transistors T. In addition, some and the others of the pixel transistors T may include different types of semiconductor materials.

For example, the first, second, fifth, sixth, and seventh transistors T1, T2, T5, T6, and T7 may be formed as P-type transistors (e.g., P-type metal oxide semiconductor field effect transistor (MOSFETs)) including respective active layers made of the polysilicon, and the third and fourth transistors T3 and T4 may be formed as N-type transistors (e.g., N-type MOSFETs) including respective active layers made of the oxide semiconductor. The transistors including the respective active layers made of the polysilicon and the transistors including the respective active layers made of the oxide semiconductor may be disposed at different layers within the circuit layer 120.

Referring to FIG. 6 in addition to FIG. 5, the pixel circuit PCA may further include an eighth transistor T8. The eighth transistor T8 may include a gate electrode connected to the fifth scan line SL5, a first electrode connected to the bias power line VOBL, and a second electrode connected to the first electrode of the first transistor T1. The eighth transistor T8 may be turned on by a fifth scan signal supplied to the fifth scan line SL5 to electrically connect the first electrode of the first transistor T1 and the bias power line VOBL to each other. When the eighth transistor T8 is turned on, a bias voltage VOBS supplied to the bias power line VOBL may be applied to the first electrode of the first transistor T1. The bias voltage VOBS may have a voltage level suitable for compensating for hysteresis characteristics of the first transistor T1. When the eighth transistor T8 is turned on, the first electrode of the first transistor T1 may be initialized to the bias voltage VOBS.

The gate electrode of the seventh transistor T7 may be connected to the fifth scan line SL5. Accordingly, the seventh transistor T7 may be turned on by the fifth scan signal supplied to the fifth scan line SL5 to connect the anode electrode of the light emitting element EL to the second initialization power line VAIL.

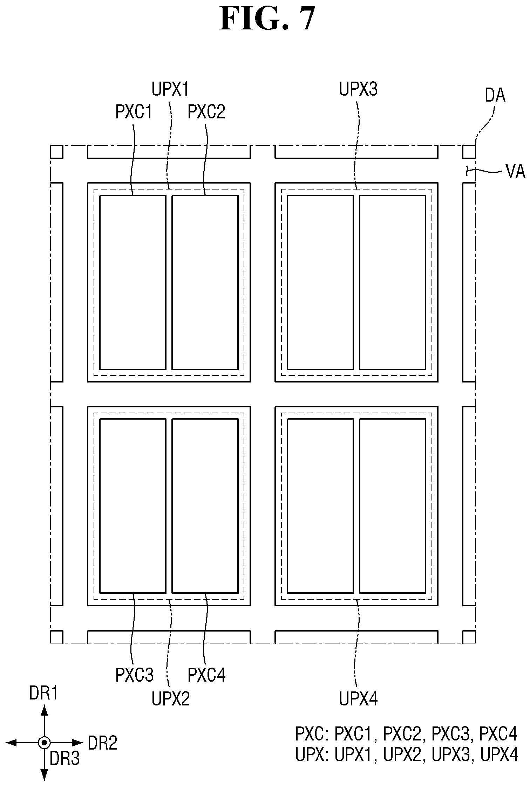

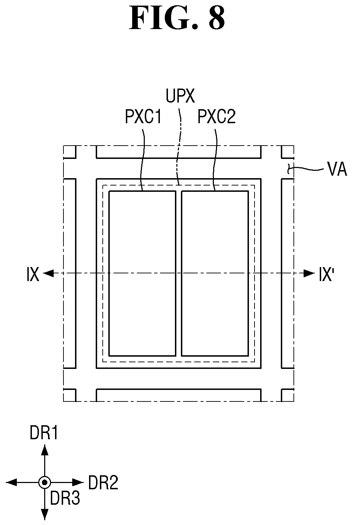

FIG. 7 is a plan view illustrating an arrangement of a plurality of pixel circuits disposed in a display area of the display device. FIG. 8 is a plan view illustrating pixel circuits disposed in a unit pixel area of FIG. 7.

Referring to FIGS. 7 and 8, the display device 10 may include a plurality of pixel circuits PXC: PXC1, PXC2, PXC3, and PXC4 disposed in the display area DA. Each of the plurality of pixel circuits PXC may be electrically connected to the light emitting elements EL included in the sub-pixels SPX1, SPX2, and SPX3 (see, e.g. FIG. 4), respectively. Electrical signals for allowing the light emitting element EL to emit light may be applied to a plurality of circuit elements included in the pixel circuit PXC.

The plurality of pixel circuits PXC may be arranged in the first direction DR1 and the second direction DR2. For example, two pixel circuits PXC adjacent to each other in the second direction DR2 may constitute one unit pixel area UPX: UPX1, UPX2, UPX3, or UPX4. The unit pixel areas UPX : UPX1, UPX2, UPX3, and UPX4 may be arranged in the first direction DR1 and the second direction DR2. A first pixel circuit PXC1 and a second pixel circuit PXC2 adjacent to each other in the second direction DR2 may constitute one first unit pixel area UPX1. A third pixel circuit PXC3 and a fourth pixel circuit PXC4 adjacent to each other in the second direction DR2 may constitute one second unit pixel area UPX2. The first unit pixel area UPX1 and the second unit pixel area UPX2 may be arranged in the first direction DR1. A third unit pixel area UPX3 and a fourth unit pixel area UPX4 may also each include two pixel circuits adjacent to each other in the second direction DR2, and may be arranged in the first direction DR1. The first unit pixel area UPX1 may be arranged in the second direction DR2 with the third unit pixel area UPX3. The second unit pixel area UPX2 may be arranged in the second direction DR2 with the fourth unit pixel area UPX4.

A plurality of lines, conductive patterns, and semiconductor layers that constitute the pixel circuit may include the same or substantially the same patterns repeated based on one unit pixel area UPX rather than the pixel circuit. For example, arrangement structures of the lines, the conductive patterns, and the semiconductor layers in the first unit pixel area UPX1 may be the same or substantially the same as those in the second unit pixel area UPX2, the third unit pixel area UPX3, and the fourth unit pixel area UPX4. The first pixel circuit PXC1 and the second pixel circuit PXC2 may each have a structure in which arrangements of the conductive patterns and the semiconductor layers are symmetrical or substantially symmetrical to each other, and patterns of the conductive patterns and the semiconductor layers constituting two pixel circuits PXC1 and PXC2 may be repeatedly arranged over the entire display area DA.

The display device 10 may include a valley portion VA disposed to surround the unit pixel area UPX. The valley portion VA may surround one unit pixel area UPX, and may surround a plurality of unit pixel areas UPX over the entire display area DA. The valley portion VA may be disposed at boundaries of the plurality of unit pixel areas UPX arranged in the first direction DR1 and the second direction DR2. The valley portion VA may be disposed to extend in the first direction DR1 and the second direction DR2, and two pixel circuits PXC may be disposed in an area surrounded by the valley portion VA while portions of the valley portions VA extending in the first direction DR1 and the second direction DR2 intersect each other. The plurality of unit pixel areas UPX may be disposed to be spaced apart from each other with the valley portion VA interposed between, and may be isolated within an area surrounded by the valley portion VA.

The valley portion VA may be formed to penetrate through a plurality of conductive layers constituting the pixel circuit PXC and an interlayer insulating layer disposed between the semiconductor layers. The valley portion VA may prevent an external shock applied to the display device 10 from being transferred to elements of the pixel circuit. In addition, the display device 10 may prevent cracks that may be formed in a plurality of insulating layers when the display device 10, including the flexible substrate 110, is folded, by including the valley portion VA surrounding an area where the pixel circuits PXC are disposed.

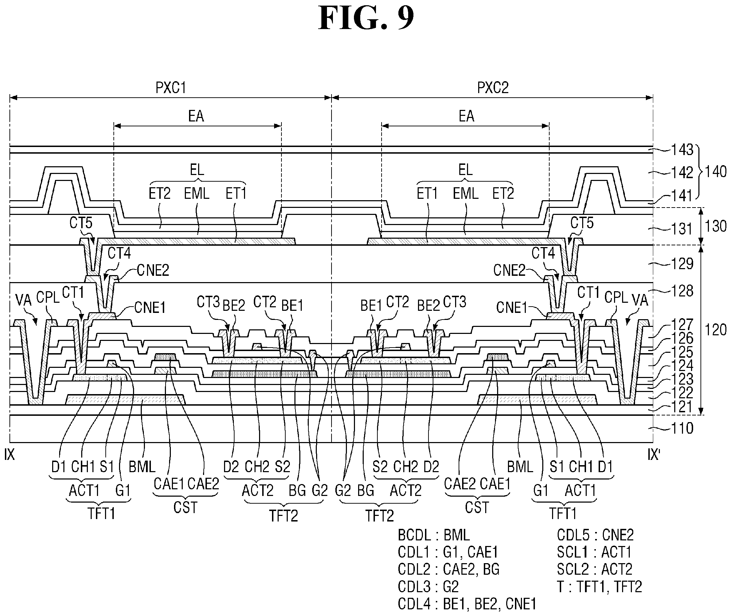

FIG. 9 is a cross-sectional view taken along the line IX-IX' of FIG. 8. FIG. 9 schematically illustrates a cross section of a portion of the display area DA corresponding to an area where one unit pixel area UPX is positioned. FIG. 9 illustrates a cross section crossing a portion of the first pixel circuit PXC1 and the second pixel circuit PXC2 adjacent to each other in the second direction DR2.

Referring to FIG. 9, the display panel 100 may include the substrate 110, and the circuit layer 120, the light emitting element layer 130, and the encapsulation layer 140 that are disposed on the substrate 110. The circuit layer 120, the light emitting element layer 130, and the encapsulation layer 140 may be sequentially disposed or stacked on the substrate 110 along the third direction DR3.

The substrate 110 may be made of a material having flexible characteristics so as to be able to be bent, folded, or rolled. The substrate 110 may be made of an insulating material, such as a polymer resin. As an example, the substrate 110 may be made of polyimide.

The circuit layer 120 may include pixel circuits PXC and lines. For example, the circuit layer 120 may include circuit elements (e.g., pixel transistors T and a capacitor Cst) constituting the pixel circuit PXC of each of the sub-pixels SPX and lines (e.g., various power lines and signal lines including power lines PL, scan lines SL, emission control lines ECL, and data lines DL) electrically connected to the sub-pixels SPX.

FIG. 9 has illustrated a first thin film transistor TFT1 (also referred to as a "first pixel transistor"), a second thin film transistor TFT2 (also referred to as a "second pixel transistor"), and a capacitor Cst that are included in the pixel circuit PXC of each sub-pixel SPX among elements that may be provided in the circuit layer 120. The first thin film transistor TFT1 may be representative of first-type transistors (e.g., P-type transistors) including a first semiconductor material (e.g., polysilicon) among the pixel transistors T constituting each pixel circuit PXC. For example, the first thin film transistor TFT1 may be one of the first, second, fifth, sixth, seventh, and/or eighth transistors T1, T2, T5, T6, T7, and/or T8. In FIG. 9, one transistor (e.g., the sixth transistor T6 of FIG. 5 or 6) connected to a light emitting element EL through at least one connection electrode (e.g., a first connection electrode CNE1 and a second connection electrode CNE2) among the first-type transistors has been illustrated as the first thin film transistor TFT1. The second thin film transistor TFT2 may be representative of second-type transistors (e.g., N-type transistors) including a second semiconductor material (e.g., an oxide semiconductor) among the pixel transistors T. For example, the second thin film transistor TFT2 may be one of the third and/or fourth transistors T3 and/or T4.

Cross-sections of the sub-pixels SPX may be variously changed in a suitable manner according to types, structures, and the like, of the respective sub-pixels SPX and the display panel 100 including the respective pixels PX. For example, positions, order of formation, and the like, of the first thin film transistor TFT1, the second thin film transistor TFT2, and the capacitor Cst may be changed.

The circuit layer 120 may include semiconductor layers and conductive layers for forming the circuit elements, the lines, and the like, and insulating films disposed between and/or around the conductive layers and the semiconductor layer. For example, the circuit layer 120 may include a first semiconductor layer SCL1 (e.g., a polysilicon semiconductor layer), a first insulating layer 123 (e.g., a first gate insulating layer), a first conductive layer CDL1 (e.g., a first gate conductive layer), a second insulating layer 124 (e.g., a second gate insulating layer), a second conductive layer CDL2 (e.g., a second gate conductive layer), a third insulating layer 125 (e.g., a first interlayer insulating layer), a second semiconductor layer SCL2 (e.g., an oxide semiconductor layer), a fourth insulating layer 126 (e.g., a third gate insulating layer), a third conductive layer CDL3 (e.g., a third gate conductive layer), a fifth insulating layer 127 (e.g., a second interlayer insulating layer), a fourth conductive layer CDL4 (e.g., a first source-drain conductive layer), and a sixth insulating layer 128 (e.g., a first via layer or a first planarization layer) that are sequentially disposed on the substrate 110 in the third direction DR3. The circuit layer 120 may further include a fifth conductive layer CDL5 (e.g., a second source-drain conductive layer) and a seventh insulating layer 129 (e.g., a second via layer or a second planarization layer) that are sequentially disposed on the sixth insulating layer 128. The circuit layer 120 may further include a bottom conductive layer BCDL disposed between the substrate 110 and the first semiconductor layer SCL1, a barrier layer 121 disposed between the substrate 110 and the bottom conductive layer BCDL, and a buffer layer 122 disposed between the bottom conductive layer BCDL and the first semiconductor layer SCL1.

The barrier layer 121 may be disposed on the substrate 110. The barrier layer 121 may protect elements disposed in the circuit layer 120 and the light emitting element layer 130 from moisture permeating through the substrate 110, which may be vulnerable to moisture permeation. The barrier layer 121 may include at least one inorganic film including an inorganic insulating material (e.g., silicon nitride, silicon oxide, silicon oxynitride, titanium oxide, aluminum oxide, or other inorganic insulating materials). A material of the barrier layer 121 may be variously changed in a suitable manner.

The bottom conductive layer BCDL may be disposed on the barrier layer 121. The bottom conductive layer BCDL may include a bottom metal layer BML overlapping with an active layer (e.g., a first active layer ACT1 and/or a second active layer ACT2) of at least one pixel transistor T and/or at least one line (or a portion of the at least one line). It has been illustrated in FIG. 9 that the bottom metal layer BML is disposed to overlap only the first active layer ACT1 of the first thin film transistor TFT1 and capacitor electrodes CAE1 and CAE2 of the capacitor Cst, but it is not limited thereto. For example, the bottom metal layer BML may also be patterned in an appropriate size and/or shape as needed and disposed only in a portion of the pixel circuit PXC or may be disposed over the entire pixel circuit PXC. As an example, the bottom metal layer BML may also be disposed only in a portion of the pixel area so as to overlap with the first transistor T1 illustrated in FIGS. 5 and 6. The bottom metal layer BML may also be utilized as a light blocking pattern, a back-gate electrode of at least one pixel transistor T, and the like.

The buffer layer 122 may be disposed on the bottom conductive layer BCDL to cover the bottom conductive layer BCDL. The buffer layer 122 may include at least one inorganic film including an inorganic insulating material.

The first thin film transistor TFT1, the second thin film transistor TFT2, and the capacitor Cst may be disposed on one surface of the substrate 110 including the buffer layer 122. The first thin film transistor TFT1 may include the first active layer ACT1 and a first gate electrode G1. The second thin film transistor TFT2 may include the second active layer ACT2 and a second gate electrode G2. The second thin film transistor TFT2 may include a back-gate electrode BG. The capacitor Cst may include a first capacitor electrode CAE1 and a second capacitor electrode CAE2.

The first semiconductor layer SCL1 may be disposed on the buffer layer 122. The first semiconductor layer SCL1 may include the first active layer ACT1 of the first thin film transistor TFT1. For example, the first semiconductor layer SCL1 may include the first active layer ACT1 of each of the first, second, fifth, sixth, seventh, and/or eighth transistors T1, T2, T5, T6, T7, and/or T8.

The first active layer ACT1 may be provided at the first semiconductor layer SCL1 and may include the first semiconductor material (e.g., polysilicon). The first active layer ACT1 may include a first channel region CH1, a first source region S1, and a first drain region D1. The first channel region CH1 may overlap with the first gate electrode G1 in the third direction DR3. The first source region S1 may be disposed on one side of the first channel region CH1, and the first drain region D1 may be disposed on the other side of the first channel region CH1. The first source region S1 and the first drain region D1 may be regions formed to have conductivity by doping a semiconductor for forming the first active layer ACT1 with ions or impurities. The first source region S1 may be a source electrode of the first thin film transistor TFT1. In another implementation, the first thin film transistor TFT1 may include a separate source electrode connected to the first source region S1. The first drain region D1 may be a drain electrode of the first thin film transistor TFT1. In another implementation, the first thin film transistor TFT1 may include a separate drain electrode connected to the first drain region D1.

The first insulating layer 123 may be disposed on the first semiconductor layer SCL1. The first insulating layer 123 may cover the first semiconductor layer SCL1.

The first conductive layer CDL1 may be disposed on the first insulating layer 123. The first conductive layer CDL1 may include the first gate electrode G1 of the first thin film transistor TFT1. The first gate electrode G1 may be disposed to overlap with a portion (e.g., the first channel region CH1) of the first active layer ACT1. The first conductive layer CDL1 may further include at least one line (or a portion of the at least one line), a conductive pattern (e.g., a bridge pattern), and/or a capacitor electrode. As an example, the first conductive layer CDL1 may further include the first capacitor electrode CAE1 of the capacitor Cst.

The first capacitor electrode CAE1 may be formed integrally with a gate electrode of at least one first thin film transistor TFT1. For example, the first capacitor electrode CAE1 may be formed integrally with the gate electrode of the first transistor T1 illustrated in FIGS. 5 and 6. As an example, the first capacitor electrode CAE1 and the gate electrode of the first transistor T1 may be formed as one conductive pattern, and the second capacitor electrode CAE2 may be disposed to overlap with the conductive pattern.

The second insulating layer 124 may be disposed on the first conductive layer CDL1. The second insulating layer 124 may cover the first conductive layer CDL1.

The second conductive layer CDL2 may be disposed on the second insulating layer 124. The second conductive layer CDL2 may include one electrode, for example, the second capacitor electrode CAE2, of the capacitor Cst. The second conductive layer CDL2 may further include at least one electrode, at least one line (or a portion of the at least one line), and/or a conductive pattern (e.g., a bridge pattern). For example, the second conductive layer CDL2 may further include the back-gate electrode BG connected to the second gate electrode G2 of the second thin film transistor TFT2.

The third insulating layer 125 may be disposed on the second conductive layer CDL2. The third insulating layer 125 may cover the second conductive layer CDL2.

The second semiconductor layer SCL2 may be disposed on the third insulating layer 125. The second semiconductor layer SCL2 may include the second active layer ACT2 of the second thin film transistor TFT2. For example, the second semiconductor layer SCL2 may include the second active layer ACT2 of each of the third and fourth transistors T3 and T4.

The second active layer ACT2 may be provided at the second semiconductor layer SCL2 and may include the second semiconductor material (e.g., an oxide semiconductor) different from the first semiconductor material. For example, the second active layer ACT2 may include IGZO (indium (In), gallium (Ga), zinc (Zn), and oxygen (O)), IGZTO (indium (In), gallium (Ga), zinc (Zn), tin (Sn), and oxygen (O)), or IGTO (indium (In), gallium (Ga), tin (Sn), and oxygen (O)), and/or the like.

The second active layer ACT2 may include a second channel region CH2, a second source region S2, and a second drain region D2. The second channel region CH2 may overlap with the second gate electrode G2 in the third direction DR3. The second source region S2 may be disposed on one side of the second channel region CH2, and the second drain region D2 may be disposed on the other side of the second channel region CH2. The second source region S2 and the second drain region D2 may be regions having conductivity by doping a semiconductor for forming the second active layer ACT2 with ions or impurities. The second source region S2 may be a source electrode of the second thin film transistor TFT2. In another implementation, the second thin film transistor TFT2 may include a separate source electrode connected to the second source region S2. The second drain region D2 may be a drain electrode of the second thin film transistor TFT2. In another implementation, the second thin film transistor TFT2 may include a separate drain electrode connected to the second drain region D2.

The fourth insulating layer 126 may be disposed on the second semiconductor layer SCL2. The fourth insulating layer 126 may cover the second semiconductor layer SCL2.

The third conductive layer CDL3 may be disposed on the fourth insulating layer 126. The third conductive layer CDL3 may include the second gate electrode G2 of the second thin film transistor TFT2. The second gate electrode G2 may be disposed to overlap with a portion (e.g., the second channel region CH2) of the second active layer ACT2. The third conductive layer CDL3 may further include at least one line (or a portion of the at least one line), a conductive pattern (e.g., a bridge pattern), and/or a capacitor electrode.

The respective electrodes, conductive patterns, and/or lines provided at the bottom conductive layer BCDL, the first conductive layer CDL1, the second conductive layer CDL2, and the third conductive layer CDL3 may each include a conductive material (e.g., at least one of molybdenum (Mo), aluminum (Al), chromium (Cr), gold (Au), titanium (Ti), nickel (Ni), neodymium (Nd), copper (Cu), and/or other metals, alloys thereof, or other conductive materials), and may each have a single-layer or multilayer structure. For example, the respective electrodes, conductive patterns, and/or lines provided at the bottom conductive layer BCDL, the first conductive layer CDL1, the second conductive layer CDL2, and the third conductive layer CDL3 may each include molybdenum (Mo) or other metal materials. At least two of the bottom conductive layer BCDL, the first conductive layer CDL1, the second conductive layer CDL2, and the third conductive layer CDL3 may include the same or substantially the same material or include different materials. A material of each of the bottom conductive layer BCDL, the first conductive layer CDL1, the second conductive layer CDL2, and the third conductive layer CDL3 is not limited, and may be variously changed in a suitable.

The fifth insulating layer 127 may be disposed on the third conductive layer CDL3. The fifth insulating layer 127 may cover the third conductive layer CDL3.

The first insulating layer 123, the second insulating layer 124, the third insulating layer 125, the fourth insulating layer 126, and the fifth insulating layer 127 may be inorganic insulating films each including an inorganic insulating material (e.g., silicon nitride, silicon oxide, silicon oxynitride, titanium oxide, aluminum oxide, or other inorganic insulating material), and may each have a single-layer or multilayer structure. At least two of the first insulating layer 123, the second insulating layer 124, the third insulating layer 125, the fourth insulating layer 126, and the fifth insulating layer 127 may include the same or substantially the same material or include different materials. A material of each of the first insulating layer 123, the second insulating layer 124, the third insulating layer 125, the fourth insulating layer 126, and the fifth insulating layer 127 may be variously changed in a suitable manner.

The fourth conductive layer CDL4 may be disposed on the fifth insulating layer 127. The fourth conductive layer CDL4 may include the first connection electrode CNE1 (or the drain electrode of the first thin film transistor TFT1), a first bridge electrode BE1 (or the source electrode of the second thin film transistor TFT2), and a second bridge electrode BE2 (or the drain electrode of the second thin film transistor TFT2). The first connection electrode CNE1 may be provided at the fourth conductive layer CDL4 and be connected to the first drain region D1 of the first active layer ACT1 through a first contact hole CT1 penetrating through the first insulating layer 123, the second insulating layer 124, the third insulating layer 125, the fourth insulating layer 126, and the fifth insulating layer 127. The first bridge electrode BE1 may be provided at the fourth conductive layer CDL4 and be connected to the second source region S2 of the second active layer ACT2 through a second contact hole CT2 penetrating through the fourth insulating layer 126 and the fifth insulating layer 127. The second bridge electrode BE2 may be connected to the second drain region D2 of the second active layer ACT2 through a third contact hole CT3 penetrating through the fourth insulating layer 126 and the fifth insulating layer 127. The fourth conductive layer CDL4 may further include at least one line (or a portion of the at least one line) and/or a conductive pattern (e.g., a bridge pattern). As an example, the fourth conductive layer CDL4 may include portions of the power lines PL (e.g., the first pixel power line VDL and/or the second pixel power line VSL of FIG. 5 or FIG. 6) provided inside and/or outside the display area DA.

The valley portion VA may be formed to penetrate through at least some of a plurality of insulating layers disposed on the barrier layer 121. For example, the valley portion VA may penetrate through at least some of the buffer layer 122, the first insulating layer 123, the second insulating layer 124, the third insulating layer 125, the fourth insulating layer 126, and the fifth insulating layer 127. The valley portion VA may penetrate through at least some of the plurality of insulating layers overlapping the first thin film transistor TFT1 and the second thin film transistor TFT2. The valley portion VA may have a maximum depth when it is formed to penetrate through all of the buffer layer 122 and the first to fifth insulating layers 123, 124, 125, 126, and 127. The valley portion VA may be formed so as not to penetrate through the semiconductor layers SCL1 and SCL2 and the conductive layers CDL1, CDL2 and CDL3 disposed between the buffer layer 122 and the fifth insulating layer 127. The valley portion VA formed in portions of the valley portion VA overlapping the semiconductor layers SCL1 and SCL2 and the conductive layers CDL1, CDL2, CDL3 and CDL4 may have a small depth. In FIG. 9, a portion of the valley portion VA penetrating through all of the buffer layer 122 and the first to fifth insulating layers 123, 124, 125, 126, and 127 has been illustrated. However, the valley portion VA may overlap with at least one of the semiconductor layers SCL1 and SCL2 and/or the conductive layers CDL1, CDL2, and CDL3 depending on a position, and in this case, a depth of the valley portion VA may become smaller.

The display device 10 includes a capping layer CPL disposed at the valley portion VA. The capping layer CPL may be disposed to overlap with the valley portion VA, and at least a portion of the capping layer CPL may be disposed on the fifth insulating layer 127. For example, the capping layer CPL may be disposed on inner sidewalls of the valley portion VA and an upper surface of a lower layer exposed by the valley portion VA. The capping layer CPL illustrated in FIG. 9 may be disposed to cover the inner sidewalls of the valley portion VA and be in direct contact with each of the barrier layer 121 and the fifth insulating layer 127.

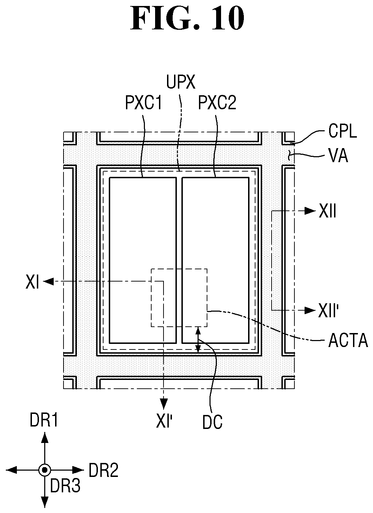

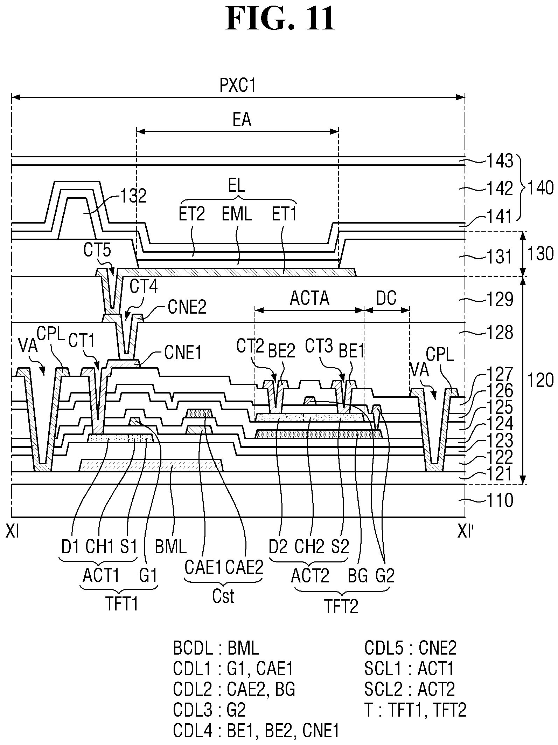

FIG. 10 is a plan view illustrating an arrangement of the unit pixel area and a semiconductor layer area of the display device. FIG. 11 is a cross-sectional view taken along the line XI-XI' of FIG. 10. FIG. 10 illustrates a planar arrangement of a semiconductor area ACTA where second semiconductor layers SCL2 (see, e.g., FIG. 9) of two pixel circuits PXC1 and PXC2 are disposed in the unit pixel area UPX and an arrangement of the valley portion VA and the capping layer CPL.

Referring to FIGS. 10 and 11 in addition to FIG. 9, the capping layer CPL is disposed to overlap with the valley portion VA. The capping layer CPL may be disposed to extend in the first direction DR1 and the second direction DR2, and may be disposed to surround the unit pixel area UPX. An arrangement of the capping layer CPL in a plan view may be substantially the same as the arrangement of the valley portion VA described above.

The capping layer CPL may be formed as a single inorganic film or a plurality of inorganic films including silicon nitride (SiNₓ), silicon oxide (SiOₓ), silicon oxynitride (SiOₓN_{y}), and/or the like. For example, the capping layer CPL may be formed as a single film of SiNₓ, a double film of SiNₓ/SiOₓ, or a triple film of SiNₓ/SiOₓ/SiNₓ. The capping layer CPL may include a conductive material, such as a metal like the fourth conductive layer CDL4. In this case, the capping layer CPL may be formed in the same process as the fourth conductive layer CDL4. The capping layer CPL may include the above-described material and cover the inner sidewalls of the valley portion VA.

The second active layers ACT2 of the second thin film transistors TFT2 included in the first pixel circuit PXC1 and the second pixel circuit PXC2 may be formed as the second semiconductor layers SCL2 including the oxide semiconductor. In the unit pixel area UPX, the second semiconductor layers SCL2 may be disposed in the semiconductor area ACTA of FIG. 10. The second semiconductor layer SCL2 of the first pixel circuit PXC1 and the second semiconductor layer SCL2 of the second pixel circuit PXC2 may each be disposed in the semiconductor area ACTA. The second semiconductor layers SCL2 may be disposed somewhat adjacent to the lower side of the unit pixel area UPX, which is one side of the unit pixel area UPX in the first direction DR1 with respect to the center of the unit pixel area UPX. Portions of the valley portion VA and the capping layer CPL extending in the second direction DR2 on the lower side of the unit pixel area UPX may be disposed adjacent to the semiconductor area ACTA.

The valley portion VA may protect the circuit elements from an external shock applied to the display device 10. The valley portion VA may be formed through a process of etching lower insulating layers after forming the fourth conductive layer CDL4, and may then be filled with a sixth insulating layer 128 to be described later. Before the sixth insulating layer 128 fills the valley portion VA, the capping layer CPL may cover the inner sidewalls of the valley portion VA, and may prevent deterioration of adjacent circuit elements caused by gas when the sixth insulating layer 128 is formed. In particular, the second thin film transistor TFT2 may include the second active layer ACT2 including the oxide semiconductor. The sixth insulating layer 128 may include an organic insulating material. The capping layer CPL may prevent gas generated in the sixth insulating layer 128 from moving to the second active layer ACT2. The display device 10 may improve (e.g., increase) shock resistance by including the valley portion VA, and may prevent the deterioration of the circuit elements that may occur when the valley portion VA is formed, through the capping layer CPL.

The capping layer CPL may cover at least portions of the inner sidewalls of the valley portion VA, and may be disposed from a lower surface of the valley portion VA or an upper surface of the barrier layer 121 exposed in the valley portion VA up to a preset height. The capping layer CPL may be disposed so that at least a portion thereof covering the inner sidewalls of the valley portion VA overlaps with at least the second semiconductor layer SCL2 in a direction parallel to an upper surface of the substrate 110 (the horizontal direction when viewed in Figure 9). For example, the capping layer CPL may cover the lower surface and inner sidewalls of the valley portion VA, and may be disposed at least up to a height at which the second semiconductor layer SCL2 is disposed. In other words, portions of the valley portion VA and the capping layer CPL may be disposed at the same level as the second semiconductor layer SCL2. That is, the valley portion VA may be formed to penetrate through each of the second insulating layer 124 disposed below the second semiconductor layer SCL2 and the third insulating layer 125 disposed on the second insulating layer 124. The capping layer CPL may be in contact with the second insulating layer 124 and the third insulating layer 125 on the inner sidewalls of the valley portion VA. The capping layer CPL may be disposed between the second semiconductor layer SCL2 and an organic insulating material disposed in the valley portion VA to prevent gas from moving from the organic insulating material to the second semiconductor layer SCL2 and prevent or substantially reduce deterioration of the semiconductor layer SCL2.

The shortest distance DC between the second active layer ACT2 including the oxide semiconductor and the capping layer CPL may be about 10 µm or less. When the valley portion VA is formed in an area within about 10 µm from the second active layer ACT2, the gas generated from the organic material filling the valley portion VA may cause deterioration of the second semiconductor layer SCL2. In order to prevent or substantially reduce the deterioration of the second semiconductor layer SCL2, the inner sidewalls of the valley portion VA formed in the area within about 10 µm from the second active layer ACT2 may be covered by the capping layer CPL, and the shortest distance DC between the second active layer ACT2 and the capping layer CPL may be about 10 µm or less.

It has been illustrated in FIGS. 10 and 11 that the capping layer CPL is disposed along the valley portion VA, but it is not limited thereto. The capping layer CPL may also be disposed only in an area of the valley portion VA adjacent to the semiconductor area ACTA to prevent deterioration of the second semiconductor layer SCL2. In some implementations, the valley portion VA is not formed within a preset distance from the semiconductor area ACTA, such that deterioration of the second semiconductor layer SCL2 may be prevented. This will be described with reference to other implementations.

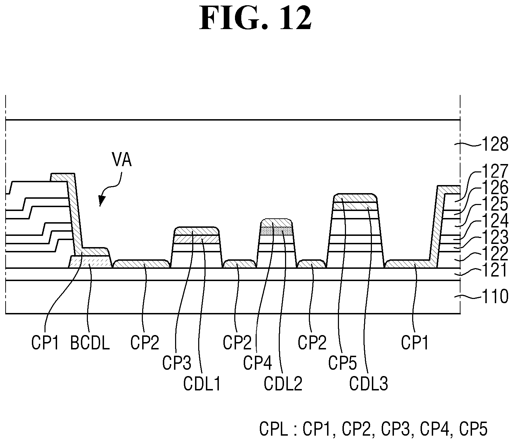

FIG. 12 is a cross-sectional view taken along the line XII-XII' of FIG. 10. FIG. 12 illustrates a cross section of a portion of the valley portion VA taken along the first direction DR1.

Referring to FIG. 12, the valley portion VA of the display device 10 may have a depth that is not constant, and the capping layer CPL may be disposed discontinuously within the valley portion VA. The valley portion VA may be formed to penetrate through a plurality of layers from the buffer layer 122 to the fifth insulating layer 127, but may not penetrate through the semiconductor layers or the conductive layers. The valley portion VA may be formed to surround the unit pixel area UPX. In portions of the valley portion VA overlapping with a plurality of conductive layers or semiconductor layers outside the unit pixel area UPX, the valley portion VA may not penetrate through the plurality of conductive layers or semiconductor layers, and a depth of the valley portion VA may become small.

For example, as illustrated in FIG. 12, patterns of the bottom conductive layer BCDL and the first to third conductive layers CDL1, CDL2, and CDL3 may be partially positioned inside the valley portion VA. A valley portion having a maximum depth may be formed in portions of the valley portion VA where the patterns are not disposed, while a depth of the valley portion VA may become small in areas where the valley portion VA overlaps with the bottom conductive layer BCDL and the first to third conductive layers CDL1, CDL2, and CDL3. In the valley portion VA, patterns of the insulating layers 123, 124, 125, and 126 through which the valley portion VA does not penetrate may remain below patterns or lines of the first to third conductive layers CDL1, CDL2, and CDL3.

The patterns may be a plurality of lines disposed on the bottom conductive layer BCDL and the first to third conductive layers CDL1, CDL2, and CDL3. The patterns may be connected to the pixel circuit PXC or may be conductive patterns electrically connected to the thin film transistors TFT1 and TFT2. For example, the patterns may be a plurality of scan lines SL, data lines DL, emission control lines ECL, power lines PL, or the like, described with reference to FIGS. 5 and 6.

The capping layer CPL may include first capping patterns CP1 disposed on the inner sidewalls of the valley portion VA, second capping patterns CP2 disposed on the upper surface of the barrier layer 121, and third and fifth capping patterns CP3, CP4, and CP5 respectively disposed on the patterns of the first to third conductive layers CDL1, CDL2, and CDL3 overlapping the valley portion VA. The capping layer CPL may include a plurality of capping patterns CP1, CP2, CP3, CP4, and CP5 spaced apart from each other within the valley portion VA. The display device 10 may include the valley portion VA of which depths are different from each other depending on an arrangement of a plurality of conductive layers CDL1, CDL2, and CDL3, the bottom conductive layer BCDL, and the semiconductor layers SCL1 and SCL2, and may include the capping layer CPL disposed along the valley portion VA but discontinuously disposed. In some implementations in which the capping layer CPL is formed along the valley portion VA and is formed to cover the inner sidewalls of the valley portion VA, portions of the capping layer CPL (e.g., CP1) may be disposed on the inner sidewalls of the valley portion VA, and the other portions of the capping layer CPL (e.g., CP2) may remain on the barrier layer 121 or may remain on the first to third conductive layers CDL1, CDL2, and CDL3 (e.g., CP3, CP4, and CP5).

Referring again to FIG. 11, the sixth insulating layer 128 may be disposed on the fourth conductive layer CDL4. The sixth insulating layer 128 may cover the fourth conductive layer CDL4. In addition, the sixth insulating layer 128 may fill the inside of the valley portion VA and may be directly disposed on the capping layer CPL.

The fifth conductive layer CDL5 may be disposed on the sixth insulating layer 128. The fifth conductive layer CDL5 may include the second connection electrode CNE2. The second connection electrode CNE2 may be provided at the fifth conductive layer CDL5 and be connected to the first connection electrode CNE1 through a fourth contact hole CT4 (or a first via hole) penetrating through the sixth insulating layer 128. The fifth conductive layer CDL5 may further include at least one line (or a portion of the at least one line) and/or a conductive pattern (e.g., a bridge pattern). As an example, the fifth conductive layer CDL5 may include portions of the power lines PL (e.g., the first pixel power line VDL and/or the second pixel power line VSL) provided inside and/or outside the display area DA.

The respective electrodes, conductive patterns, and/or lines provided at the fourth conductive layer CDL4 and the fifth conductive layer CDL5 may each include a conductive material (e.g., at least one of molybdenum (Mo), aluminum (Al), chromium (Cr), gold (Au), titanium (Ti), nickel (Ni), neodymium (Nd), copper (Cu), and/or other metals, alloys thereof, or other conductive materials), and may each have a single-layer or multilayer structure. For example, the respective electrodes, conductive patterns, and/or lines provided at the fourth conductive layer CDL4 and the fifth conductive layer CDL5 may each be formed in a triple-layer structure of titanium/aluminum/titanium (Ti/Al/Ti). The fourth conductive layer CDL4 and the fifth conductive layer CDL5 may include the same or substantially the same material or include different materials. A material of each of the fourth conductive layer CDL4 and the fifth conductive layer CDL5 may be variously changed in a suitable manner.

The seventh insulating layer 129 may be disposed on the fifth conductive layer CDL5. The seventh insulating layer 129 may cover the fifth conductive layer CDL5.

The sixth insulating layer 128 and the seventh insulating layer 129 may be organic insulating films including an organic insulating material (e.g., an acrylic resin, an epoxy resin, a phenolic resin, a polyamide resin, a polyimide resin, or other organic insulating materials) in order to planarize the circuit layer 120, and may each have a single-layer or multilayer structure. The sixth insulating layer 128 and the seventh insulating layer 129 may include the same or substantially the same material or include different materials. A material of each of the sixth insulating layer 128 and the seventh insulating layer 129 may be variously changed in a suitable manner.

The light emitting element layer 130 may include a pixel defining film 131 partitioning emission areas EA of the pixels PX and respective light emitting elements EL positioned in the respective emission areas EA. The light emitting element layer 130 may further include a spacer 132 disposed on a portion of the pixel defining film 131.

Each light emitting element EL may include a first electrode ET1 (e.g., an anode electrode) connected to at least one transistor T (e.g., the first thin film transistor TFT1), included in a corresponding sub-pixel SPX (see, e.g., FIG. 5 or 6), through the first connection electrode CNE1, the second connection electrode CNE2, and the like, and a light emitting layer EML. Each light emitting element EL may include a second electrode ET2 (e.g., a cathode electrode) that is sequentially disposed on the first electrode ET1. The light emitting element EL may further include a first intermediate layer (e.g., a hole layer including a hole transporting layer) interposed between the first electrode ET1 and the light emitting layer EML and a second intermediate layer (e.g., an electron layer including an electron transporting layer) interposed between the light emitting layer EML and the second electrode ET2.

The first electrode ET1 of the light emitting element EL may include a conductive material and may be disposed on the circuit layer 120. For example, the first electrode ET1 may be disposed on the seventh insulating layer 129 so as to correspond to each emission area EA. The first electrode ET1 may be connected to the second connection electrode CNE2 through a fifth contact hole CT5 (or a second via hole) penetrating through the seventh insulating layer 129.

The first electrode ET1 may include a metal material having high reflectivity. For example, the first electrode ET1 may have a single-layer structure of molybdenum (Mo), titanium (Ti), copper (Cu), or aluminum (Al) or have a multilayer structure (e.g., ITO/Mg, ITO/MgF, ITO/Ag, ITO/Ag/ITO, and/or the like) including indium tin oxide (ITO), indium zinc oxide (IZO), zinc oxide (ZnO), or indium oxide (In₂O₃), and silver (Ag), magnesium (Mg), aluminum (Al), platinum (Pt), lead (Pb), gold (Au), nickel (Ni), or the like.

The light emitting layer EML of the light emitting element EL may include a high molecular material or a low molecular material. Each sub-pixel SPX may have a corresponding light emitting layer EML, and the light emitting layer EML of each sub-pixel SPX may emit visible light of a color corresponding to the corresponding sub-pixel SPX. The light emitting layer EML may be a common layer shared by the sub-pixels SPX of different colors, and wavelength conversion layers and/or color filters corresponding to colors (or wavelength bands) of light to be emitted from the respective sub-pixels SPX may be disposed in emission areas EA of at least some sub-pixels SPX.

The second electrode ET2 of the light emitting element EL may include a conductive material, and may be connected to the second pixel power line VSL. The second electrode ET2 may be a common layer formed over the entire display area DA in a form in which it covers the light emitting layers EML and the pixel defining film 131. The second electrode ET2 may be made of a transparent conductive material (TCM) such as ITO or IZO capable of transmitting (e.g., passing) light therethrough or a semi-transmissive conductive material, such as magnesium (Mg), silver (Ag), or an alloy of magnesium (Mg) and silver (Ag). When the second electrode ET2 is made of the semi-transmissive conductive material, an improvement (e.g., increase) in light emission efficiency due to a micro cavity effect may be expected.

The pixel defining film 131 may have openings corresponding to the respective emission areas EA and surround the emission areas EA. For example, the pixel defining film 131 may be formed to cover an edge of the first electrode ET1 of the light emitting element EL, and may include an opening exposing the other portion of the first electrode ET1. An area where the exposed first electrode ET1 and the light emitting layer EML overlap with each other (or an area including such an area) may be defined as the emission area EA of each pixel PX.

The pixel defining film 131 may include at least one organic film including an organic insulating material. For example, the pixel defining film 131 may include a polyacrylates resin, an epoxy resin, a phenolic resin, a polyamides resin, a polyimides resin, an unsaturated polyesters resin, a polyphenyleneethers resin, a polyphenylenesulfides resin, benzocyclobutene (BCB), or other organic insulating materials.

The spacer 132 may be disposed on a portion of the pixel defining film 131. The spacer 132 may include at least one organic film including an organic insulating material. The spacer 132 may include the same or substantially the same material as the pixel defining film 131 or include a different material from the pixel defining film 131. The pixel defining film 131 and the spacer 132 may be sequentially formed through respective mask processes. The pixel defining film 131 and the spacer 132 may be simultaneously formed using a halftone mask. In this case, the pixel defining layer 131 and the spacer 132 may be regarded as a single insulating film integral with each other. The organic insulating material constituting the spacer 132 is not particularly limited, and may be variously changed in a suitable manner.

The encapsulation layer 140 may be disposed on the light emitting element layer 130 in the main area MA (see, e.g. FIG. 1). For example, the encapsulation layer 140 may be disposed in the display area DA (see, e.g. FIG. 1) and the non-display area NA (see, e.g. FIG. 1) so as to cover the light emitting element layer 130. The encapsulation layer 140 may block or reduce permeation of oxygen or moisture into the light emitting element layer 130 and alleviate (e.g., prevent) an electrical or physical shock on the circuit layer 120 and the light emitting element layer 130.

The encapsulation layer 140 may include a first inorganic encapsulation film 141, an organic encapsulation film 142, and a second inorganic encapsulation film 143 that are sequentially disposed on the light emitting element layer 130. The first inorganic encapsulation film 141 and the second inorganic encapsulation film 143 may each include an inorganic material, and the organic encapsulation film 142 may include an organic material.

The display device 10 according to some embodiments may include the valley portion VA surrounding an area where the plurality of pixel circuits PXC are disposed, and the capping layer CPL covering the inner sidewalls of the valley portion VA. The valley portion VA of the display device 10 may prevent damage to the circuit elements from an external shock applied to the display device 10. In addition, when the display device 10 has flexible characteristics, cracks that may be formed in the plurality of insulating layers disposed on the substrate 110 when the substrate 110 is folded may be prevented by the valley portion VA. Furthermore, deterioration of the oxide semiconductor due to the gas generated from the organic material filling the valley portion VA may be prevented or reduced by including the capping layer CPL disposed on the inner sidewalls of the valley portion VA.

Hereinafter, various implementations of the display device 10 will be described with reference to other drawings.

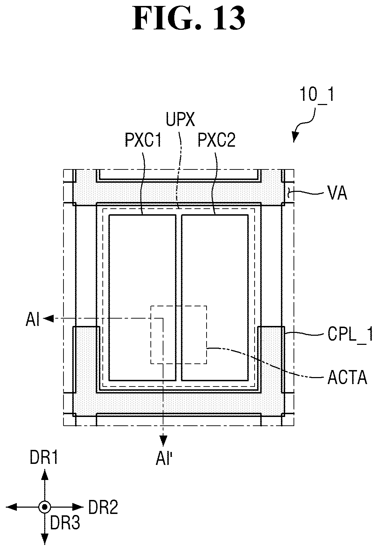

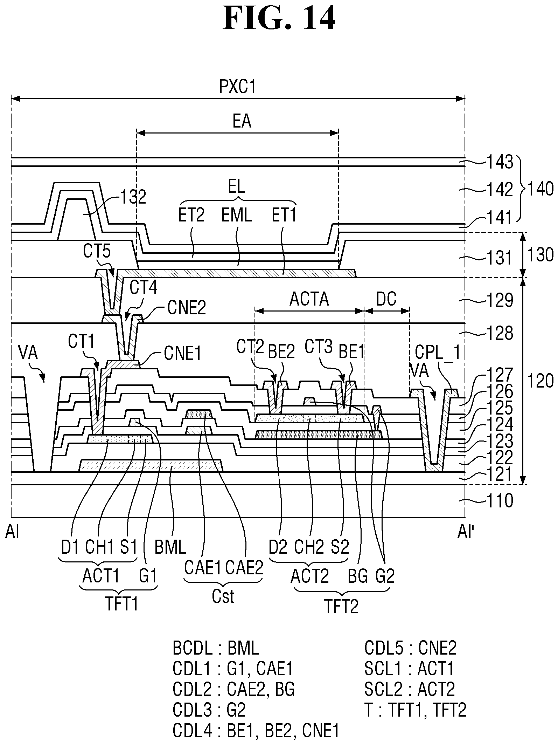

FIG. 13 is a plan view illustrating a unit pixel area and a valley portion of a display device. FIG. 14 is a cross-sectional view taken along the line A1-A1' of FIG. 13.

Referring to FIGS. 13 and 14, in a display device 10_1, a capping layer CPL_1 may be disposed only around the semiconductor area ACTA. The capping layer CPL_1 may be disposed to overlap with the valley portion VA, but may not be disposed over the entire valley portion VA and may be disposed to correspond to the periphery of the semiconductor area ACTA where the second semiconductor layer SCL2 including the oxide semiconductor is disposed. For example, the capping layer CPL_1 may be disposed to overlap with a portion of the valley portion VA disposed on the lower side of the semiconductor area ACTA and extending in the second direction DR2. In addition, the capping layer CPL_1 may be disposed only on a portion adjacent to the semiconductor area ACTA, that is, the lower side with respect to the center of the unit pixel area UPX, in a portion of the valley portion VA extending in the first direction DR1. The plurality of unit pixel areas UPX may be repeatedly arranged in the first direction DR1 and the second direction DR2, and accordingly, the semiconductor areas ACTA may also be repeatedly arranged in the first direction DR1 and the second direction DR2 over the entire display area DA. The capping layer CPL_1 disposed over the entire display area DA may be disposed as patterns that are not connected to each other and are spaced apart from each other, and an area exposed without the capping layer CPL1 may be formed in a partial area of a portion of the valley portion VA extending in the first direction DR1.

As described above, the capping layer CPL_1 may prevent the gas generated from the organic insulating material of the sixth insulating layer 128 disposed in the valley portion VA from moving to the second semiconductor layer SCL2 including the oxide semiconductor. The capping layer CPL_1 may be disposed in an area within about 10 µm from the second active layer ACT2 of the second semiconductor layer SCL2 to prevent deterioration of the second active layer ACT2 due to the movement of the gas. Accordingly, the capping layer CPL_1 may not be disposed in an area about 10 µm or more from the second active layer ACT2. According to another implementation, the capping layer CPL_1 may be selectively disposed only on a portion of the valley portion VA adjacent to the second semiconductor layer SCL2. For example, the capping layer CPL_1 may be disposed only in a partial area of the valley portion VA so as to correspond to the semiconductor area ACTA disposed adjacent to the lower side of the unit pixel area UPX.

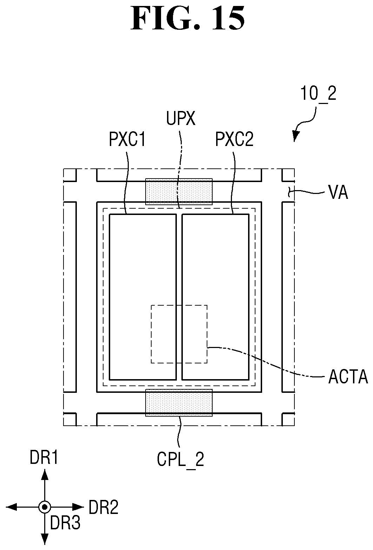

FIG. 15 is a plan view illustrating a unit pixel area and a valley portion of a display device.

Referring to FIG. 15, in a display device 10_2, a capping layer CPL_2 may be disposed only in an area of the valley portion VA most adjacent to the semiconductor area ACTA. For example, the capping layer CPL_2 may have the same or substantially the same width as a width of the semiconductor area ACTA measured in the second direction DR2, and may be disposed on a portion of the valley portion VA extending in the second direction DR2. When an interval DC (see, e.g., FIG. 10) between the second active layer ACT2 of the semiconductor area ACTA and the portion of the valley portion VA extending in the second direction DR2 is less than about 10 µm, the capping layer CPL_2 may be disposed to correspond only to the corresponding area. The capping layer CPL_2 may be disposed in a form in which patterns having a preset width in the second direction DR2 are spaced apart from each other and repeatedly arranged in the first direction DR1 and the second direction DR2 over the entire display area DA.

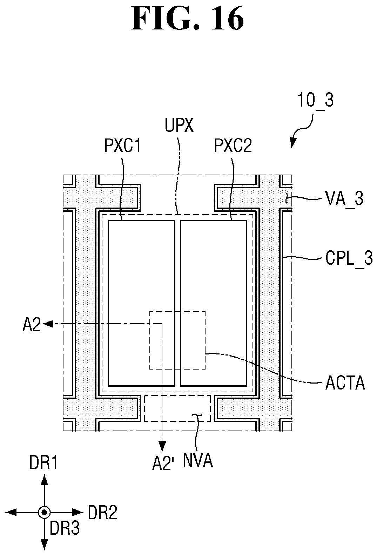

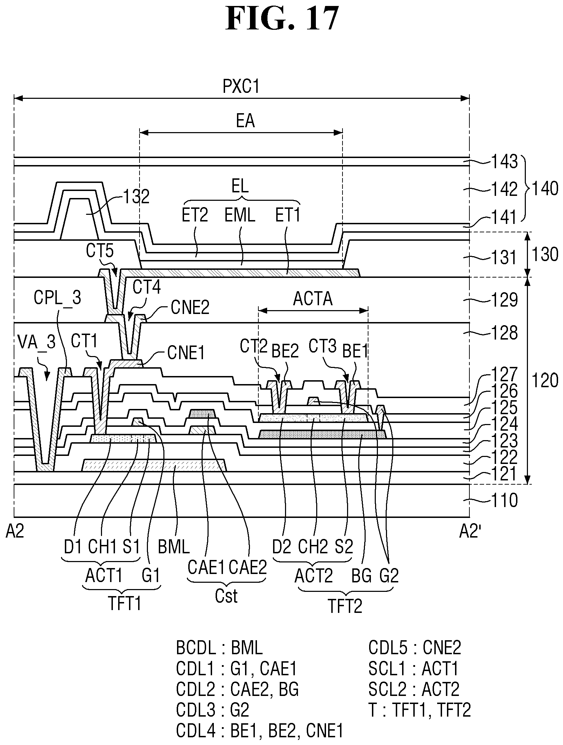

FIG. 16 is a plan view illustrating a unit pixel area and a valley portion of a display device. FIG. 17 is a cross-sectional view taken along the line A2-A2' of FIG. 16.

Referring to FIGS. 16 and 17, in a display device 10_3, a valley portion VA_3 may be formed in an area not most adjacent to the semiconductor area ACTA. The valley portion VA_3 may be disposed in a linear shape in which it extends in the first direction DR1 over the entire display area DA and may have a shape in which it has protrusion portions partially protruding to both sides in the second direction DR2. An area NVA where the valley portion VA_3 is not formed may be disposed between portions of the valley portion VA_3 that protrude in the second direction DR2. The area NVA where the valley portion VA_3 is not formed may be positioned between the unit pixel areas UPX arranged in the second direction DR2 or between the semiconductor areas ACTA of the unit pixel areas UPX arranged in the second direction DR2.

A capping layer CPL_3 may be formed to overlap with the valley portion VA_3, and may be disposed in a linear shape in which it extends in the first direction DR1 over the entire display area DA and may have a shape in which it has protrusion portions partially protruding to both sides in the second direction DR2, like the valley portion VA_3.

Because the valley portion VA_3 is not selectively formed in the area adjacent to the semiconductor area ACTA, deterioration of the second active layer ACT2 of the second semiconductor layer SCL2 due to movement of the gas generated from the organic insulating material of the sixth insulating layer 128 disposed in the valley portion VA_3 may be prevented or reduced.

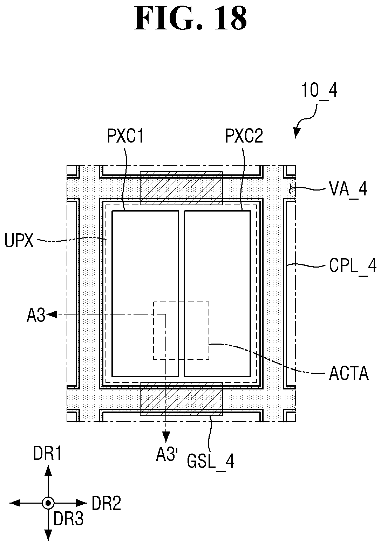

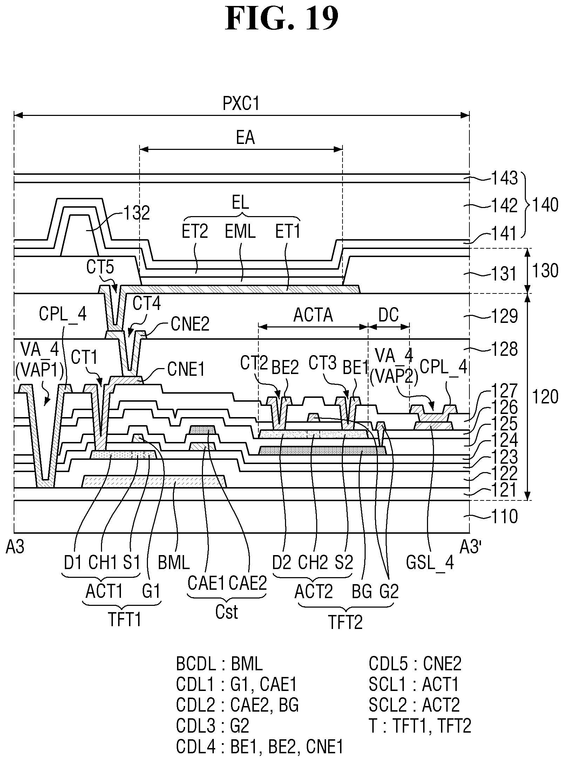

FIG. 18 is a plan view illustrating a unit pixel area and a valley portion of a display device. FIG. 19 is a cross-sectional view taken along the line A3-A3' of FIG. 18.

Referring to FIGS. 18 and 19, a display device 10_4 may include a step pattern GSL_4 overlapping with a valley portion VA_4. The step pattern GSL_4 may be disposed at the same layer as the third conductive layer CDL3 disposed above the second semiconductor layer SCL2. The step pattern GSL_4 may be disposed on the fourth insulating layer 126 and disposed in an area adjacent to the semiconductor area ACTA. For example, the step pattern GSL_4 may be disposed on the lower side of the unit pixel area UPX, and may be disposed to be spaced apart from the semiconductor area ACTA in the first direction DR1 and overlap with a portion of the valley portion VA_4 extending in the second direction DR2.

The valley portion VA_4 may penetrate through the buffer layer 122 and the plurality of insulating layers 123, 124, 125, 126, and 127, but may not penetrate through the conductive layers CDL1, CDL2, and CDL3 or the semiconductor layers SCL1 and SCL2. In a process of forming the valley portion VA_4, the conductive layers CDL1, CDL2, and CDL3 or the semiconductor layers SCL1 and SCL2 may serve as an etching stopper. In an area where the step pattern GSL_4 is disposed, the valley portion VA_4 may not penetrate through the step pattern GSL_4, and an area of the valley portion VA_4 overlapping the step pattern GSL_4 may have a smaller depth than other portions. The valley portion VA_4 may include a first portion VAP1 that does not overlap with the step pattern GSL_4 and penetrates up to the buffer layer 122 and a second portion VAP2 that overlaps the step pattern GSL_4 and does not penetrate through the step pattern GSL_4 and layers disposed below the step pattern GSL_4. The first portion VAP1 of the valley portion VA_4 may have a greater depth than the second portion VAP2 of the valley portion VA_4.

A capping layer CPL_4 may be disposed to correspond to the valley portion VA_4, and may be disposed on the step pattern GSL_4. A portion of the capping layer CPL_4 disposed on the step pattern GSL_4 may be in direct contact with an upper surface of the step pattern GSL_4. A portion of the capping layer CPL_4 disposed in the first portion VAP1 of the valley portion VA_4 may be in direct contact with the barrier layer 121. A portion of the capping layer CPL_4 disposed in the second portion VAP2 of the valley portion VA_4 may be in direct contact with the step pattern GSL_4.

The step pattern GSL_4 may be disposed at the same layer as the third conductive layer CDL3 disposed above the second semiconductor layer SCL2, and a portion of the valley portion VA_4 overlapping with the step pattern GSL_4 may penetrate through the fifth insulating layer 127 but may not penetrate through the fourth insulating layer 126. That is, the portion of the valley portion VA_4 overlapping with the step pattern GSL_4 may not overlap with the second active layer ACT2 of the second semiconductor layer SCL2 in the horizontal direction (parallel to the surface of the substrate). The step pattern GSL_4 may be disposed in an area adjacent to the semiconductor area ACTA or the second active layer ACT2 of the second semiconductor layer SCL2, and accordingly, the valley portion VA_4 may not be formed in an area horizontal to the second active layer ACT2 of the second semiconductor layer SCL2. The display device 10_4 may include the step pattern GSL_4, such that a partial area of the valley portion VA_4 may be selectively formed at a small depth, and deterioration of the second active layer ACT2 of the second semiconductor layer SCL2 due to the movement of the gas generated from the organic insulating material may be prevented or reduced.

The capping layer CPL may be omitted if the valley portion VA_4 and the second semiconductor layer SCL2 of the semiconductor area ACTA may be separated from each other through the step pattern GSL_4 and the movement of the gas generated from the organic insulating material may be prevented through the step pattern GSL_4.

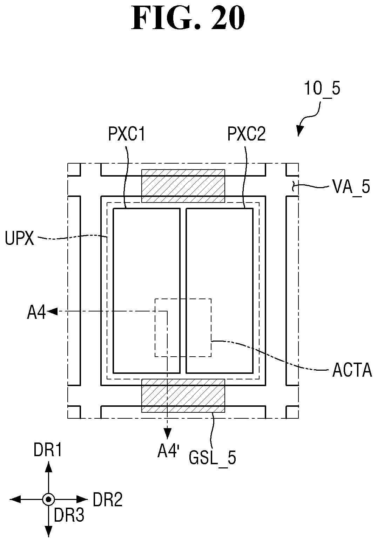

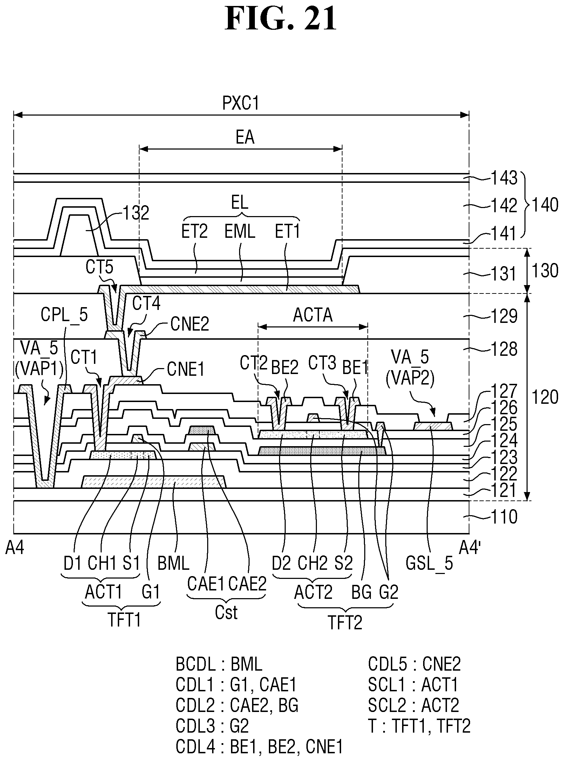

FIG. 20 is a plan view illustrating a unit pixel area and a valley portion of a display device. FIG. 21 is a cross-sectional view taken along the line A4-A4' of FIG. 20.

Referring to FIGS. 20 and 21, a display device 10_5 may include a step pattern GSL_5 overlapping a valley portion VA_5. The step pattern GSL_5 may be disposed adjacent to the second semiconductor layer SCL2 of the semiconductor area ACTA, and an area of the valley portion VA_5 overlapping with the step pattern GSL_5 may have a smaller depth than other portions. The valley portion VA_5 may include a first portion VAP1 that does not overlap with the step pattern GSL_5 and penetrates up to the buffer layer 122. The valley portion VA_5 may include a second portion VAP2 that overlaps with the step pattern GSL_5 and does not penetrate through the step pattern GSL_5 and layers disposed below the step pattern GSL_5. The first portion VAP1 of the valley portion VA_5 may have a greater depth than the second portion VAP2 of the valley portion VA_5. Accordingly, the second active layer ACT2 of the second semiconductor layer SCL2 may not overlap with the valley portion VA_5 in the horizontal direction, and even though the capping layer CPL is omitted in the display device 10_5, deterioration due to the gas generated from the organic insulating material may be prevented or reduced. These implementations are different from FIGS. 18 and 19 in that the capping layer CPL is omitted.

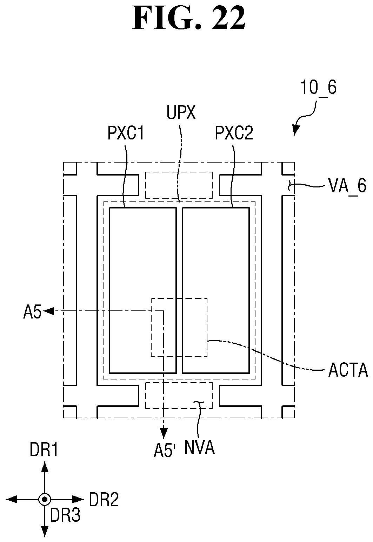

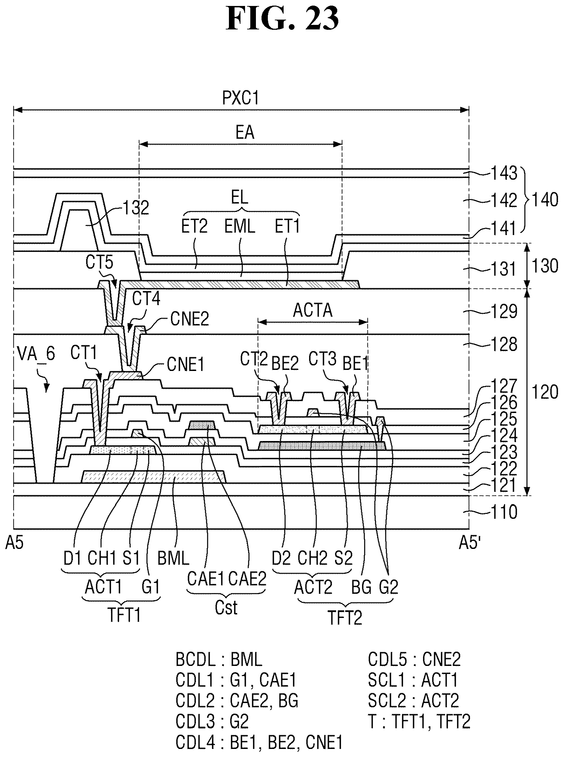

FIG. 22 is a plan view illustrating a unit pixel area and a valley portion of a display device. FIG. 23 is a cross-sectional view taken along line A5-A5' of FIG. 22.

Referring to FIGS. 22 and 23, in a display device 10_6, a valley portion VA_6 may be formed in an area not most adjacent to the semiconductor area ACTA. The valley portion VA_6 may be disposed in a linear shape in which it extends in the first direction DR1 over the entire display area DA and may have a shape in which it has protrusion portions partially protruding to both sides in the second direction DR2.

Because the valley portion VA_6 is not selectively formed in the area adjacent to the semiconductor area ACTA, even though the capping layer CPL is omitted in the display device 10_6, deterioration of the second active layer ACT2 of the second semiconductor layer SCL2 due to the movement of the gas generated from the organic insulating material of the sixth insulating layer 128 disposed in the valley portion VA_6 may be prevented or reduced. These implementations are different from FIGS. 16 and 17 in that the capping layer CPL is omitted.

## Claims

1. A display device comprising:
a plurality of unit pixel areas (UPX) arranged in a first direction and a second direction crossing the first direction and in which first thin film transistors and second thin film transistors are located, each one of first thin film transistors comprising a first active layer (ACT1), and each one of the second thin film transistors comprising a second active layer (ACT2) at a different layer from the first active layer and including an oxide semiconductor;
a valley portion (VA) at boundaries of the unit pixel areas, and penetrating through at least some of a plurality of insulating layers overlapping with the first thin film transistor and the second thin film transistor; and
a capping layer (CPL) positioned to overlap with the valley portion and to cover inner sidewalls of the valley portion, the capping layer being on a portion of the valley portion that is adjacent to a semiconductor area of one of the unit pixel areas where the second active layer (ACT2) is located, and is between the second active layer and an organic insulating material in the valley portion.

2. The display device of claim 1, wherein the shortest distance between the capping layer and the second active layer is about 10 µm or less.

3. The display device of claim 1 or 2, wherein the capping layer comprises at least one of SiNₓ, SiOₓ, or SiOₓN_{y}.

4. The display device of claim 1, 2 or 3, further comprising a plurality of lines electrically connected to at least one of the first thin film transistors or the second thin film transistors and extending in the first direction or the second direction,
wherein at least a portion of the valley portion overlaps with any one of the lines.

5. The display device of claim 4, wherein the depth of a portion of the valley portion that does not overlap with the lines is greater than the depth of the portion of the valley portion that overlaps with any one of the lines.

6. The display device of claim 5, wherein the capping layer comprises first capping patterns on the inner sidewalls of the valley portion and second capping patterns that are not connected to the first capping patterns and located on the lines that overlap with the valley portion.

7. The display device of any one of the preceding claims, wherein the valley portion is configured to extend in the first direction and the second direction to surround the unit pixel area, and
the capping layer comprises portions overlapping with the valley portion and extending in the first direction and the second direction.

8. The display device of claim 7, wherein the second active layer is adjacent to a portion of the valley portion extending in the second direction, and
wherein the capping layer is on the portion of the valley portion extending in the second direction.

9. The display device of claim 8, wherein the width of the capping layer measured in the second direction is about the same as the width measured in the second direction of the semiconductor area.

10. The display device of claim 8, wherein the portion of the capping layer extending in the first direction is located on a portion of the valley portion extending in the first direction, and
wherein the capping layer is not located on at least a portion of the portion of the valley portion extending in the first direction.

11. The display device of any one of claims 7 to 10, wherein the capping layer is configured to extend in the first direction and the second direction to surround the unit pixel area.

12. The display device of any one of the preceding claims, wherein the valley portion comprises a portion extending in the first direction and a portion protruding in the second direction from the portion extending in the first direction and located at the boundary of the unit pixel area, and
wherein the valley portion and the capping layer are not located between semiconductor areas of the unit pixel areas arranged in the second direction.

13. The display device of any one of the preceding claims, further comprising:
a gate electrode on the second active layer and a step pattern located at the same layer as the gate electrode and overlapping with a portion of the valley portion extending in the second direction,
wherein the capping layer is on and in direct contact with the step pattern.

14. The display device of claim 13, wherein a portion of the valley portion on the step pattern has a smaller depth than other portions, and
the capping layer on the step pattern does not overlap with the second active layer in the horizontal direction.
